(19) Europäisches Patentamt / European Patent Office / Office européen des brevets

(11) **EP 4 563 610 A1**

(12) **EUROPEAN PATENT APPLICATION**
published in accordance with Art. 153(4) EPC

(43) Date of publication:
**04.06.2025 Bulletin 2025/23**

(21) Application number: **23846460.6**

(22) Date of filing: **24.07.2023**

(51) International Patent Classification (IPC):
***C08F 299/00*** *(2006.01)*

(52) Cooperative Patent Classification (CPC):
**C08F 299/00**

(86) International application number:
**PCT/JP2023/027019**

(87) International publication number:
**WO 2024/024730 (01.02.2024 Gazette 2024/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.07.2022 JP 2022118159**

(71) Applicant: **MITSUBISHI GAS CHEMICAL COMPANY, INC.**
**Chiyoda-ku**
**Tokyo 100-8324 (JP)**

(72) Inventors:
- **MIYAMOTO, Makoto**
**Tokyo 125-8601 (JP)**
- **ARAI, Yuji**
**Tokyo 125-8601 (JP)**
- **IIJIMA, Takayuki**
**Yokkaichi-shi, Mie 510-0886 (JP)**

(74) Representative: **Müller-Boré & Partner Patentanwälte PartG mbB**
**Friedenheimer Brücke 21**
**80639 München (DE)**

(54) **RESIN COMPOSITION CONTAINING BIFUNCTIONAL PHENYLENE ETHER RESIN**

(57) It has been desired to develop a phenylene ether resin having more excellent dielectric properties. The present invention provides a phenylene ether resin composition having a number average molecular weight (Mn) of 800 to 3,000, wherein the phenylene ether resin composition comprises a resin $\alpha$ represented by the following general formula (1) and a resin $\beta$ represented by the following general formula (2), and the phenylene ether resin composition is characterized in that the content of the resin $\beta$ to the resin $\alpha$ (the content of the resin $\beta$/the content of the resin $\alpha$) is 20 to 200 ppm. In the general formula (2), at least one of $L_1$ to $L_8$ is represented by the following general formula (3).

[Formula 1]

the general formula (1)

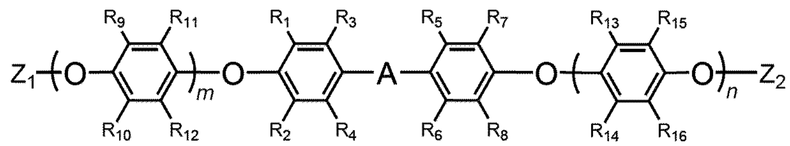

the general formula (2)

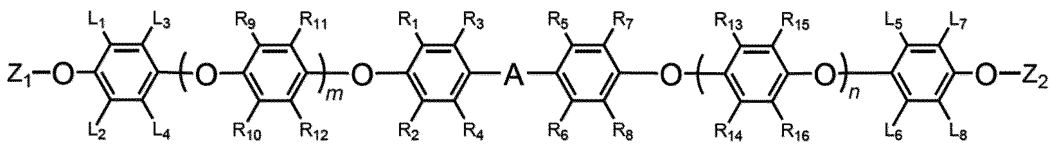

EP 4 563 610 A1

the general formula (3)

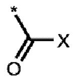

## Description

### Technical Field

The present invention relates to a resin composition containing a bifunctional phenylene ether resin.

### Background Art

Since phenylene ether resin has excellent dielectric properties, heat resistance, flame retardance, toughness, processability, low water absorbability, etc., it has been used in various industrial fields such as electrical and electronic fields and automotive fields for a wide variety of applications including molding, adhesion, and coating.

In particular, in the electrical and electronic fields, as the frequency band used becomes higher, the substrate materials of printed wiring boards used in various electronic devices are increasingly required to have excellent dielectric properties.

For example, Patent Literature 1 discloses an oligomeric body of bifunctional phenylene ether having phenolic hydroxyl groups at both ends, which is obtained by oxidative polymerization of a specific divalent phenol and a specific monovalent phenol. The oligomeric body of Patent Literature 1 is sufficiently soluble in a ketone solvent, is compatible with thermosetting resins, and has properties similar to those of PPE polymers, such as low dielectric properties and toughness. Furthermore, the denaturation reaction of the terminal phenolic hydroxyl groups can be easily carried out in a ketone solvent.

Patent Literature 2 discloses a compound in which the terminal end of a bifunctional polyphenylene ether oligomer is converted to a vinyl group. The compound of Patent Literature 2 has a high glass transition point when it is cured, and also has a low dielectric constant and a low dissipation factor. Thus, this compound exhibits well-balanced properties inherited from the excellent properties of polyphenylene ether.

### Citation List

### Patent Literature

Patent Literature 1: JP Patent Publication (Kokai) No. 2003-12796 A
Patent Literature 2: JP Patent Publication (Kokai) No. 2004-59644 A

## Summary of Invention

### Technical Problem

However, it has been desired to develop a phenylene ether resin having more excellent dielectric properties.

### Solution to Problem

As a result of intensive studies, the present inventors have found that a bifunctional phenylene ether resin composition having excellent dielectric properties (in particular, a low dissipation factor) can be obtained by setting the content of a bifunctional phenylene ether resin having a specific structure such as an aldehyde group or an alkoxy group in the resin composition to be in a specific range in the resin composition, thereby completing the present invention.

The present invention may provide the following aspects.

[1] A phenylene ether resin composition having a number average molecular weight (Mn) of 800 to 3,000,

the phenylene ether resin composition comprising a resin $\alpha$ represented by the following general formula (1) and a resin $\beta$ represented by the following general formula (2), wherein
the phenylene ether resin composition is characterized in that the content of the resin $\beta$ to the resin $\alpha$ (the content of the resin $\beta$/the content of the resin $\alpha$) is 20 to 200 ppm:

[Formula 1]
the general formula (1)

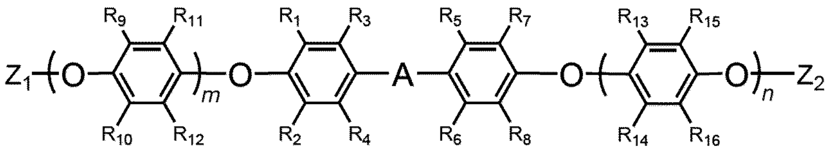

wherein A represents a single bond or a linear, branched or cyclic hydrocarbon containing 10 or less carbon atoms; $Z_1$ and $Z_2$, which may be the same or different, each represent a hydrogen atom or a unit containing a polymerizable double bonding group; $R_1$ to $R_{16}$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group or a substituted aryl group; m and n each represent an integer of 0 to 20, and at least one is an integer of 1 to 20; and at least one of $R_1$ to $R_{16}$ represents a methyl group, and

[Formula 2]

the general formula (2)

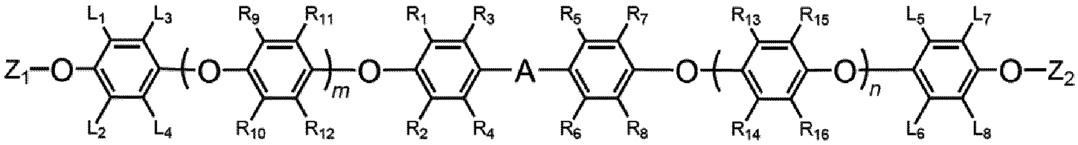

wherein A, $Z_1$, $Z_2$, $R_1$ to $R_{16}$, m and n are the same as those in the general formula (1); and $L_1$ to $L_8$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group, a substituted aryl group or the following general formula (3), wherein at least one of $L_1$ to $L_8$ is represented by the following general formula (3):

[Formula 3]

the general formula (3)

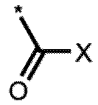

wherein X is selected from the group consisting of a hydrogen atom, a hydroxyl group, a linear or branched alkyl group containing 6 or less carbon atoms, a substituted alkyl group, an alkenyl group, a substituted alkenyl group, an aryl group and a substituted aryl group, and X is preferably a hydrogen atom; and * represents a bonding hand.

[2] The phenylene ether resin composition according to the above [1], further comprising a resin $\gamma$ represented by the following general formula (4), wherein

the content of the resin $\gamma$ to the resin $\alpha$ (the content of the resin y/the content of the resin $\alpha$) is 150 to 400 ppm:

[Formula 4]

the general formula (4)

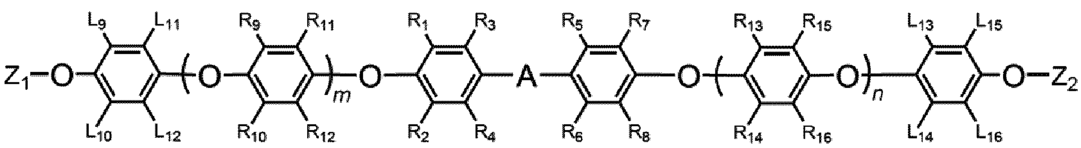

wherein A, $Z_1$, $Z_2$, $R_1$ to $R_{16}$, m and n are the same as those in the general formula (1); $L_9$ to $L_{16}$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl

group, a substituted aryl group or the following general formula (5), wherein at least one of $L_9$ to $L_{16}$ is represented by the following general formula (5):

[Formula 5]

the general formula (5)

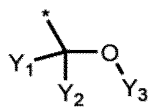

wherein $Y_1$ and $Y_2$ are selected from the group consisting of a hydrogen atom, a linear or branched alkyl group containing 6 or less carbon atoms, a substituted alkyl group, an alkenyl group, a substituted alkenyl group, an aryl group and a substituted aryl group; $Y_3$ is selected from the group consisting of a hydrogen atom, a linear or branched alkyl group containing 6 or less carbon atoms, a substituted alkyl group, an alkenyl group and a substituted alkenyl group; and * represents a bonding hand.

[3] The phenylene ether resin composition according to the above [1], wherein, in the general formulae (1) and (2), A is a single bond.
[4] The phenylene ether resin composition according to the above [1], wherein, in the general formulae (1) and (2), $R_1$, $R_2$, $R_3$, $R_6$, $R_7$ and $R_8$ each represent a methyl group, and $R_4$ and $R_5$ each represent a hydrogen atom.
[5] The phenylene ether resin composition according to the above [1], wherein

in the general formulae (1) and (2), $R_9$, $R_{10}$, $R_{15}$ and $R_{16}$ each represent a methyl group, and $R_{11}$, $R_{12}$, $R_{13}$ and $R_{14}$ each represent a hydrogen atom, and
in the general formula (2), $L_1$, $L_2$, $L_7$ and $L_8$ each represent a methyl group or the general formula (3), and $L_3$, $L_4$, $L_5$ and $L_6$ each represent a hydrogen atom, wherein at least one of $L_1$, $L_2$, $L_7$ and $L_8$ represents the general formula (3).

[6] The phenylene ether resin composition according to the above [1], wherein

in the general formulae (1) and (2), $Z_1$ and $Z_2$ are represented by either the following general formula (6) or (7):

[Formula 6]

the general formula (6)

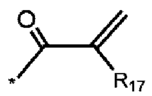

wherein $R_{17}$ represents a hydrogen atom or a methyl group, and $R_{17}$ is preferably a methyl group; and * represents a bonding hand, or

[Formula 7]

the general formula (7)

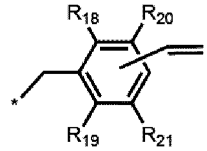

wherein $R_{18}$ to $R_{21}$, which may be the same or different, each represent a hydrogen atom, a halogen atom, a linear or branched alkyl group containing 6 or less carbon atoms or a phenyl group, and $R_{18}$ to $R_{21}$ are preferably all hydrogen atoms; and * represents a bonding hand.

[7] The phenylene ether resin composition according to the above [6], wherein, in the general formulae (1) and (2), $Z_1$

and $Z_2$ are represented by the general formula (7).
[8] The phenylene ether resin composition according to the above [1], wherein, in the general formula (3), X represents a hydrogen atom.
[9] The phenylene ether resin composition according to the above [2], wherein, in the general formula (5), $Y_3$ represents a methyl group.
[10] A curable film obtained using the phenylene ether resin composition according to any one of the above [1] to [9].
[11] A laminated plate obtained using the phenylene ether resin composition according to any one of the above [1] to [9].

## Advantageous Effects of Invention

According to one embodiment of the present invention, a bifunctional phenylene ether resin composition having a low dissipation factor can be provided.

## Description of Embodiments

Hereinafter, the present invention will be described in detail by exemplifying synthetic examples, examples, and the like, but the present invention is not limited to the exemplified synthetic examples, examples, and the like. The present invention can be carried out by any method changed within a range that is not greatly deviated from the content of the present invention.
The present invention relates to a bifunctional phenylene ether resin composition. The bifunctional phenylene ether resin included in the present invention is a resin $\alpha$ represented by the following general formula (1).

[Formula 8]

the general formula (1)

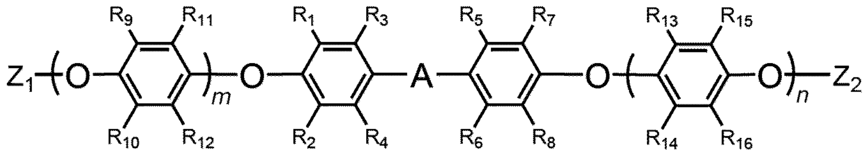

In the general formula (1), A represents a single bond or a linear, branched or cyclic hydrocarbon containing 10 or less (preferably 1 to 4) carbon atoms. $Z_1$ and $Z_2$, which may be the same or different, each represent a hydrogen atom or a unit containing a polymerizable double bonding group. $R_1$ to $R_{16}$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group or a substituted aryl group. m and n each represent an integer of 0 to 20, and at least one is an integer of 1 to 20. Preferably, at least one of $R_1$ to $R_{16}$ represents a methyl group.
The bifunctional phenylene ether resin included in the present invention, other than the resin $\alpha$, is a resin $\beta$ represented by the following general formula (2).

[Formula 9]

the general formula (2)

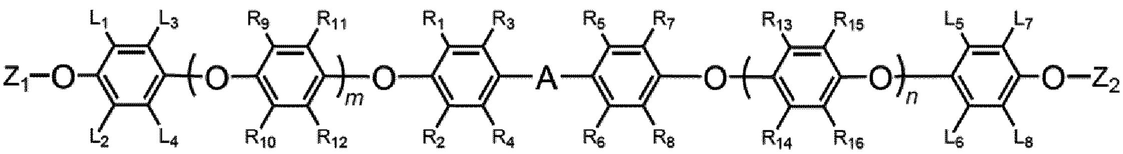

In the general formula (2), A, $Z_1$, $Z_2$, $R_1$ to $R_{16}$, m and n are the same as those in the above general formula (1). $L_1$ to $L_8$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group, a substituted aryl group or the following general formula (3). At least one of $L_1$ to $L_8$ is represented by the following general formula (3).

[Formula 10]

the general formula (3)

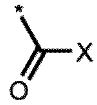

In the general formula (3), X is selected from the group consisting of a hydrogen atom, a hydroxyl group, a linear or branched alkyl group containing 6 or less carbon atoms, a substituted alkyl group, an alkenyl group, a substituted alkenyl group, an aryl group and a substituted aryl group. Preferably, X is a hydrogen atom or a hydroxyl group, or a linear or branched alkyl group containing 6 or less carbon atoms, a substituted alkyl group, an alkenyl group, a substituted alkenyl group, an aryl group or a substituted aryl group, in which 1 to 3 hydrogen atoms bind to a carbon atom positioned adjacent to a -C=O group. * represents a bonding hand.

At the end of the resin β, there exist a phenylene group having the groups $L_1$ to $L_4$ and a phenylene group having the groups $L_5$ to $L_8$. As mentioned above, at least one of the groups $L_1$ to $L_8$ is a group represented by the general formula (3). That is, at least one of the groups $L_1$ to $L_8$ has a carbonyl group structure such as an aldehyde group or a ketone group, or a carboxy group.

In the present invention, the content of the resin β is smaller than that of the resin α. The content of the resin β to the resin α, "the content of the resin β/the content of the resin α," is 20 to 200 ppm, preferably 20 to 180 ppm, more preferably 20 to 150 ppm, further preferably 20 to 100 ppm, and particularly preferably 20 to 50 ppm. If the content of the resin β is too large, the value of the dissipation factor may become too high, and the dielectric properties may deteriorate. On the other hand, if the content of the resin β is too small, the oxidation polymerization reaction itself may not be completed, a large amount of monomer may remain, and the polymer may not be elongated to a desired molecular weight.

In the present invention, the content of the resin β is calculated using a measurement value obtained by proton nuclear magnetic resonance ($^1$H-NMR). First, the phenylene ether resin composition of the present invention, into which other components other than a phenylene ether resin and components used in the production of the phenylene ether resin are not added, is concentrated and dried to prepare powders, and the powder are then dissolved in a deuterated chloroform solvent or the like to prepare a solution sample for measurement. The sample is then subjected to $^1$H-NMR measurement, and the integrated intensity of the peak at 1.9 to 2.3 ppm is set to be "1,000". The present peak is attributed to the number of protons of the methyl group substituted on the benzene ring in the resin composition.

For example, when the general formula (3) represents an aldehyde group in the resin β (the resin β in this case is also referred to as an "aldehyde body"), the content of the aldehyde body is calculated according to the following equation:

$$\text{Content [ppm] of aldehyde body} = [\{(I_{9.5\text{-}12.5}/P_a) \times M_a\}/\{(1{,}000/P_p) \times M_p\}] \times 10^6.$$

In the equation,

$I_{9.5\text{-}12.5}$ represents an integrated intensity at 9.5 to 12.5 ppm. This is the measurement value of the number of protons of the aldehyde group in the resin composition.
$P_a$ is the number of protons of the aldehyde group, namely, it is "1,"
$M_a$ is the molecular weight of the aldehyde group, namely, it is 29,
$P_p$ is the number of protons of the methyl group substituted on the benzene ring of the phenylene ether resin α. It is theoretically calculated from the amount of a monomer added.
$M_p$ is the theoretical molecular weight of phenylene ether resin α. It is theoretically calculated from the amount of a monomer added.

As an example, with regard to monomers used upon the synthesis of a phenylene ether resin composition, when 2,2',3,3',5,5'-hexamethyl-(1,1'-biphenyl1)-4,4'-diol (HMBP) is used as divalent phenol and 2,6-dimethylphenol is used as monovalent phenol, the numerical values of various items are as follows.

[Table 1]

| | Divalent phenol | Monovalent phenol | Total |
|---|---|---|---|
| | HMBP | 2,6 - Dimethylphenol | - |
| Molecular weight | 270.4 | 122.2 | - |

(continued)

| | Divalent phenol | Monovalent phenol | Total |
|---|---|---|---|
| Added amount [g] | 46.2 | 125.3 | - |
| Added amount [mol] | 0.17 | 1.03 | - |
| Ratio | 1 | 6 | **Theoretical molecular weight of phenylene ether resin** |
| Theoretical molecular weight | 268.4 | 723.1 | **991** |
| Number of methyl groups substituted on benzene ring in single molecule of monomer [pcs] | 6 | 2 | **-** |
| Total number of methyl groups substituted on benzene ring [pcs] | 6 | 12 | **Number of protons of methyl group substituted on benzene ring of phenylene ether resin** |
| Total number of protons of methyl group substituted on benzene ring [pcs] | 18 | 36 | **54** |

When the integrated intensity at 9.5 to 12.5 ppm is set to be "0.1," the content of the aldehyde body is as follows.

Content [ppm] of aldehyde body = [{(0.1/1) x 29}/{(1,000/54) x 991}] x $10^6$ = 158.

When the general formula (3) represents a group other than the aldehyde group, the content (ppm) of the resin β can be calculated by a method according to the above-described method of calculating the aldehyde body.
For example, when X is a hydroxyl group (i.e. when the general formula (3) represents a carboxy group), the content (ppm) of the resin β can be calculated according to the following equation:

$$\text{Content (ppm) of resin } \beta = [\{(I_{9.5\text{-}12.5}/P_b) \times M_b\}/\{(1{,}000/P_p) \times M_p\}] \times 10^6.$$

In the equation,

$I_{9.5\text{-}12.5}$ represents the integrated intensity at 9.5 to 12.5 ppm. This is the measurement value of the number of protons of the carboxy group in the resin composition.
$P_b$ is the number of protons of the carboxy group, namely, it is "1."
$M_b$ is the molecular weight of the carboxy group, namely, it is 45.
$P_p$ is the number of protons of the methyl group substituted on the benzene ring of the phenylene ether resin α. It is theoretically calculated from the amount of a monomer added.
$M_p$ is the theoretical molecular weight of phenylene ether resin α. It is theoretically calculated from the amount of a monomer added.

In addition, for example, when X is a linear or branched alkyl group containing 6 or less carbon atoms, a substituted alkyl group, an alkenyl group, a substituted alkenyl group, an aryl group or a substituted aryl group, in which 1 to 3 hydrogen atoms bind to a carbon atom positioned adjacent to a -C=O group, the content [ppm] of the resin β can be calculated according to the following equation:

$$\text{Content (ppm) of the resin } \beta = [\{(I_{2.5\text{-}3.1}/P_c) \times M_c\}/\{(1{,}000/P_p) \times M_p\}] \times 10^6.$$

In the equation,

$I_{2.5\text{-}3.1}$ is the measurement value of the number of protons binding to a carbon atom adjacent to the carbonyl group, in X of the general formula (3) in the resin composition.
$P_c$ is the number of protons of the above-described group, namely, it is 1, 2 or 3.
$M_c$ is the total molecular weight of the carbonyl group (-C(=O)), the carbon atom binding to the carbonyl group, and the

hydrogen atom binding to the carbon atom, namely, it is 41,42 or 43.
$P_p$ is the number of protons of the methyl group binding to the benzene ring of the phenylene ether resin α, and it was theoretically calculated from the amount of a monomer added.
$M_p$ is the theoretical molecular weight of the phenylene ether resin α, and it was theoretically calculated from the amount of a monomer added.

It is preferable that the present invention includes the resin γ represented by the following general formula (4) as a bifunctional phenylene ether resin, as well as the resin α and the resin β.

[Formula 11]

the general formula (4)

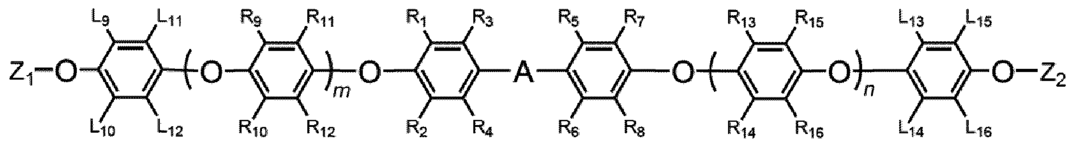

In the general formula (4), A, $Z_1$, $Z_2$, $R_1$ to $R_{16}$, m and n are the same as those in the above general formula (1). $L_9$ to $L_{16}$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group, a substituted aryl group or the following general formula (5). At least one of $L_9$ to $L_{16}$ is represented by the following general formula (5).

[Formula 12]

the general formula (5)

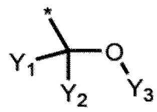

In the general formula (5), $Y_1$ and $Y_2$ are selected from the group consisting of a hydrogen atom, a linear or branched alkyl group containing 6 or less carbon atoms, a substituted alkyl group, an alkenyl group, a substituted alkenyl group, an aryl group and a substituted aryl group. $Y_3$ is selected from the group consisting of a hydrogen atom, a linear or branched alkyl group containing 6 or less carbon atoms, a substituted alkyl group, an alkenyl group and a substituted alkenyl group. Preferably, $Y_3$ is selected from the group consisting of a linear or branched alkyl group containing 6 or less carbon atoms, a substituted alkyl group, an alkenyl group, and a substituted alkenyl group, In $Y_3$, 1 to 3 hydrogen atoms bind to a carbon atom positioned adjacent to an oxygen atom. * represents a bonding hand.

In the present invention, the content of the resin γ is smaller than that of the resin α. The resin γ has a phenylene group having the groups $L_9$ to $L_{12}$ and a phenylene group having the groups $L_{13}$ to $L_{16}$ at the end. As described above, at least one of the groups $L_9$ to $L_{16}$ is the group represented by the general formula (5). That is to say, at least one of the groups $L_9$ to $L_{16}$ comprises a hydroxy group, or an alkoxy group such as a methoxy group.

The content of the resin γ to the resin α, "the content of the resin y/the content of the resin α," is preferably 150 to 400 ppm, more preferably 150 to 350 ppm, further preferably 150 to 250 ppm, and particularly preferably 150 to 200 ppm. If the content of the resin γ is too large, the value of the dissipation factor may become too high, and thus, the dielectric properties may deteriorate. On the other hand, if the content of the resin γ is too small, the oxidation polymerization reaction itself may not be completed, a large amount of monomer may remain, and the polymer may not be elongated to a desired molecular weight.

The content of the resin γ can also be obtained in the manner as that for the resin β. Specifically, the content of the resin γ is calculated using the measurement value obtained by proton nuclear magnetic resonance ($^1$H-NMR).

First, the phenylene ether resin composition of the present invention, into which other components other than a phenylene ether resin and components used in the production of the phenylene ether resin are not added, is concentrated and dried to prepare powders, and the powder are then dissolved in a deuterated chloroform solvent or the like to prepare a solution sample for measurement. The sample is then subjected to $^1$H-NMR measurement, and the integrated intensity of the peak at 1.9 to 2.3 ppm is set to be "1,000". The present peak is attributed to the number of protons of the methyl group substituted on the benzene ring in the resin composition.

Next, the content of the resin γ is calculated according to the following equation:

$$\text{Content [ppm] of resin } \gamma = [\{(I_{3.2\text{-}3.6}/P_{\gamma}) \times M_{\gamma}\}/\{(1{,}000/P_p) \times M_p\}] \times 10^6.$$

In the equation,

$I_{3.2\text{-}3.6}$ represents the integrated intensity at 3.2 to 3.6 ppm. This is the measurement value of the number of protons attached to a carbon atom in the group $Y_3$, wherein the carbon atom is positioned adjacent to an oxygen atom.
$P_{\gamma}$ is the number of protons attached to a carbon atom in the group $Y_3$, wherein the carbon atom is positioned adjacent to an oxygen atom.
$M_{\gamma}$ is the total value of the atomic weight of oxygen atom that is 16 and the molecular weight of the group $Y_3$.
$P_p$ is the number of protons of the methyl group substituted on the benzene ring of the phenylene ether resin α. It is theoretically calculated from the amount of a monomer added.
$M_p$ is the theoretical molecular weight of the phenylene ether resin α. It is theoretically calculated from the amount of a monomer added.

For example, in the resin γ, when the general formula (5) includes a methoxy group, namely, when $Y_3$ in the general formula (5) is a methyl group (hereinafter this resin is called a "methoxy body" at times), the content of the methoxy body is calculated according to the following equation:

$$\text{Content [ppm] of methoxy body} = [\{(I_{3.2\text{-}3.6}/P_m) \times M_m\}/\{(1{,}000/P_p) \times M_p\}] \times 10^6.$$

In the equation,

$I_{3.2\text{-}3.6}$ represents the integrated intensity at 3.2 to 3.6 ppm. It is the measurement value of the number of protons of the methoxy group in the resin composition.
$P_m$ is the number of protons of the methoxy group. Since the methoxy group is $-OCH_3$, it is "3."
$M_m$ is the molecular weight of the methoxy group that is 31.
$P_p$ is the number of protons of the methyl group substituted on the benzene ring of the phenylene ether resin α. It is theoretically calculated from the amount of a monomer added.
$M_p$ is the theoretical molecular weight of the phenylene ether resin α. It is theoretically calculated from the amount of a monomer added.

Moreover, for example, in the resin γ, when the general formula (5) includes a hydroxy group, namely, when $Y_3$ in the general formula (5) is a hydrogen atom, the content (ppm) of the resin γ can be calculated by a method according to the above-described method of calculating the methoxy body. Specifically, the content (ppm) of the resin γ is calculated according to the following equation:

$$\text{Content [ppm] of resin } \gamma = [\{(I_{6.0\text{-}8.0}/P_h) \times M_h\}/\{(1{,}000/P_p) \times M_p\}] \times 10^6.$$

In the equation,

$I_{6.0\text{-}8.0}$ represents the integrated intensity at 6.0 to 8.0 ppm. It is the measurement value of the number of protons of the hydroxy group in the resin composition.
$P_h$ is the number of protons of the hydroxy group. Since the hydroxy group is -OH, it is "1."
$M_h$ is the molecular weight of the hydroxy group that is 17.
$P_p$ is the number of protons of the methyl group substituted on the benzene ring of the phenylene ether resin α. It is theoretically calculated from the amount of a monomer added.
$M_p$ is the theoretical molecular weight of the phenylene ether resin α. It is theoretically calculated from the amount of a monomer added.

As an example, with regard to monomers used upon the synthesis of a phenylene ether resin composition, when 2,2',3,3',5,5'-hexamethyl-(1,1'-biphenyl)-4,4'-diol (HMBP) is used as divalent phenol and 2,6-dimethylphenol is used as monovalent phenol, the numerical values of various items are as shown in the above Table 1. When the integrated intensity at 3.2 to 3.6 ppm is set to be "0.4," the content of the methoxy body is as follows.

$$\text{Content [ppm] of methoxy body} = [\{(0.4/3) \times 31\}/\{(1{,}000/54) \times 991\}] \times 10^6 = 225.$$

In one preferred aspect of the present invention, X in the above general formula (3) is a hydrogen atom.

In one preferred aspect of the present invention, in the above general formula (5), $Y_3$ is a methyl group, and in particular, $Y_1$ and $Y_2$ are hydrogen atoms and $Y_3$ is a methyl group.

In one preferred aspect of the present invention, in both of the above general formulae (1) and (2), A is a single bond. More preferably, in all of the above general formulae (1), (2) and (4), A is a single bond.

In one preferred aspect of the present invention, in the above general formulae (1) and (2), $R_1$, $R_2$, $R_3$, $R_6$, $R_7$ and $R_8$ each represent a methyl group, and $R_4$ and $R_5$ each represent a hydrogen atom. More preferably, in the above general formulae (1), (2) and (4), $R_1$, $R_2$, $R_3$, $R_6$, $R_7$ and $R_8$ each represent a methyl group, and $R_4$ and $R_5$ each represent a hydrogen atom.

In one preferred aspect of the present invention, in the above general formulae (1) and (2), $R_9$, $R_{10}$, $R_{15}$ and $R_{16}$ each represent a methyl group, and $R_{11}$, $R_{12}$, $R_{13}$ and $R_{14}$ each represent a hydrogen atom, and in the above general formula (2), $L_1$, $L_2$, $L_7$ and $L_8$ each represent a methyl group or the above general formula (3), $L_3$, $L_4$, $L_5$ and $L_6$ each represent a hydrogen atom, and at least one of $L_1$, $L_2$, $L_7$ and $L_8$ represents the general formula (3). More preferably, in the above general formulae (1), (2) and (4), $R_9$, $R_{10}$, $R_{15}$ and $R_{16}$ each represent a methyl group, and $R_{11}$, $R_{12}$, $R_{13}$ and $R_{14}$ each represent a hydrogen atom, and in the above general formula (2), $L_1$, $L_2$, $L_7$ and $L_8$ each represent a methyl group or the above general formula (3), $L_3$, $L_4$, $L_5$ and $L_6$ each represent a hydrogen atom, and at least one of $L_1$, $L_2$, $L_7$ and $L_8$ represents the general formula (3), and in the above general formula (4), $L_9$, $L_{10}$, $L_{15}$ and $L_{16}$ each represent a methyl group or the above general formula (5), $L_{11}$, $L_{12}$, $L_{13}$ and $L_{14}$ each represent a hydrogen atom, and at least one of $L_9$, $L_{10}$, $L_{15}$ and $L_{16}$ represents the general formula (5).

In one preferred aspect of the present invention, in the above general formulae (1) and (2), $Z_1$ and $Z_2$ represent either the following general formula (6) or (7). More preferably, in the above general formulae (1), (2) and (4), $Z_1$ and $Z_2$ represent either the following general formula (6) or (7). In this aspect, the phenylene ether resins $\alpha$, $\beta$, and $\gamma$ have, as a crosslinkable group, a (meth)acryl group (in a case where at least one of $Z_1$ and $Z_2$ is represented by the following general formula (6)) or substituted or unsubstituted styryl group (in a case where at least one of $Z_1$ and $Z_2$ is represented by the following general formula (7); also referred to as a vinylphenyl group).

[Formula 13]

the general formula (6)

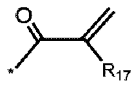

In the general formula (6), $R_{17}$ represents a hydrogen atom or a methyl group. * represents a bonding hand.

[Formula 14]

the general formula (7)

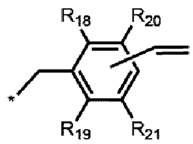

In the general formula (7), $R_{18}$ to $R_{21}$, which may be the same or different, each represent a hydrogen atom, a halogen atom, a linear or branched alkyl group containing 6 or less carbon atoms or phenyl group. * represents a bonding hand.

In one preferred aspect of the present invention, from the viewpoints that polymerization can be carried out without using polymerization initiators, and that more excellent dielectric properties can be achieved, in the above general formulae (1) and (2), at least one of $Z_1$ and $Z_2$ represents the above general formula (7), and in particular, both $Z_1$ and $Z_2$ represent the above general formula (7). More preferably, in the above general formulae (1), (2) and (4), at least one of $Z_1$ and $Z_2$ represents the above general formula (7), and in particular, both $Z_1$ and Z represent the above general formula (7). **In** this aspect, the phenylene ether resins $\alpha$, $\beta$, and $\gamma$ have, as a crosslinkable group, a substituted or unsubstituted styryl group.

In one preferred aspect of the present invention, in the above general formulae (1), (2) and (4), A represents a single bond, $R_1$, $R_2$, $R_7$ and $R_8$ each represent a methyl group, and $R_4$ and $R_5$ each represent a hydrogen atom. More preferably, A represents a single bond, $R_1$, $R_2$, $R_3$, $R_6$, $R_7$ and $R_8$ each represent a methyl group, and $R_4$ and $R_5$ each represent a hydrogen atom.

In one preferred aspect of the present invention, in the above general formulae (1), (2) and (4), A represents a single bond, $R_1$, $R_2$, $R_3$, $R_6$, $R_7$ and $R_8$ each represent a methyl group, $R_4$ and $R_5$ each represent a hydrogen atom, $R_9$, $R_{10}$, $R_{15}$ and $R_{16}$ each represent a methyl group, and $R_{11}$, $R_{12}$, $R_{13}$ and $R_{14}$ each represent a hydrogen atom, and in the general formula (2), $L_1$, $L_2$, $L_7$ and $L_8$ each represent a methyl group or the above general formula (3), $L_3$, $L_4$, $L_5$ and $L_6$ each represent a hydrogen atom, and at least one of $L_1$, $L_2$, $L_7$ and $L_8$ represents the general formula (3), and in the general formula (4), $L_9$, $L_{10}$, $L_{15}$ and $L_{16}$ each represent a methyl group or the above general formula (5), $L_{11}$, $L_{12}$, $L_{13}$, $L_{14}$ each represent a hydrogen atom, and at least one of $L_9$, $L_{10}$, $L_{15}$ and $L_{16}$ represents the general formula (5).

In one preferred aspect of the present invention, in the above general formulae (1), (2) and (4), A represents a single bond, $R_1$, $R_2$, $R_3$, $R_6$, $R_7$ and $R_8$ each represent a methyl group, $R_4$ and $R_5$ each represent a hydrogen atom, $R_9$, $R_{10}$, $R_{15}$ and $R_{16}$ each represent a methyl group, $R_{11}$, $R_{12}$, $R_{13}$ and $R_{14}$ each represent a hydrogen atom, and $Z_1$ and $Z_2$ represent either the above general formula (6) or (7), and in the general formula (2), $L_1$, $L_2$, $L_7$ and $L_8$ each represent a methyl group or the above general formula (3), $L_3$, $L_4$, $L_5$ and $L_6$ each represent a hydrogen atom, and at least one of $L_1$, $L_2$, $L_7$ and $L_8$ represents the general formula (3), and in the general formula (4), $L_9$, $L_{10}$, $L_{15}$ and $L_{16}$ each represent a methyl group or the above general formula (5), $L_{11}$, $L_{12}$, $L_{13}$, $L_{14}$ each represent a hydrogen atom, and at least one of $L_9$, $L_{10}$, $L_{15}$ and $L_{16}$ represents the general formula (5).

In one preferred aspect of the present invention, in the above general formulae (1), (2) and (4), A represents a single bond, $R_1$, $R_2$, $R_3$, $R_6$, $R_7$ and $R_8$ each represent a methyl group, $R_4$ and $R_5$ each represent a hydrogen atom, $R_9$, $R_{10}$, $R_{15}$ and $R_{16}$ each represent a methyl group, $R_{11}$, $R_{12}$, $R_{13}$ and $R_{14}$ each represent a hydrogen atom, $Z_1$ and $Z_2$ each represent the above general formula (7), and in the general formula (2), $L_1$, $L_2$, $L_7$ and $L_8$ each represent a methyl group or the above general formula (3), $L_3$, $L_4$, $L_5$ and $L_6$ each represent a hydrogen atom, at least one of $L_1$, $L_2$, $L_7$ and $L_8$ represents the general formula (3), and in the general formula (4), $L_9$, $L_{10}$, $L_{15}$ and $L_{16}$ each represent a methyl group or the above general formula (5), $L_{11}$, $L_{12}$, $L_{13}$, $L_{14}$ each represent a hydrogen atom, and at least one of $L_9$, $L_{10}$, $L_{15}$ and $L_{16}$ represents the general formula (5).

As specific examples of the phenylene ether resin represented by the above general formula (1), the resins represented by the following structural formulae are particularly preferable.

[Formula 15]

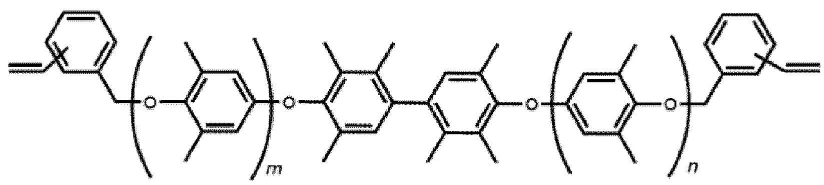

[Formula 16]

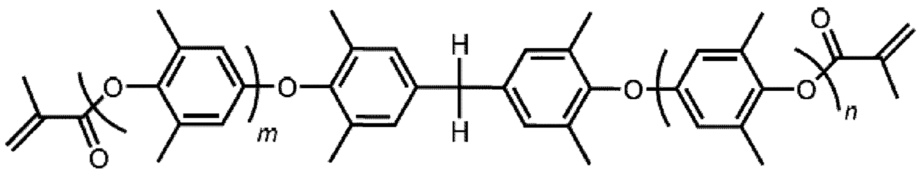

[Formula 17]

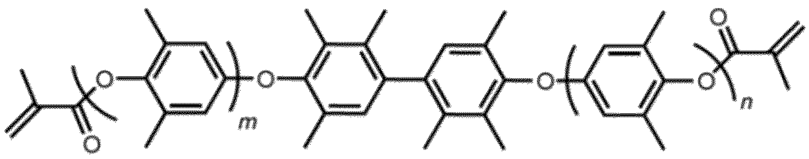

The phenylene ether resin of the present invention has a number average molecular weight (Mn) of 800 to 3,000, preferably 900 to 2,500, more preferably 950 to 2,300, and particularly preferably 1,000 to 2,200.

On the other hand, although the weight average molecular weight (Mw) of the present phenylene ether resin is not particularly limited, from the viewpoint of achieving both dielectric properties and solubility in solvents, it is preferably 900 to 7,000, and more preferably 1,000 to 6,000.

In the present invention, the number average molecular weight and the weight average molecular weight are the

values relative to polystyrene, which are measured using gel permeation chromatography according to the usual method, as shown in the Examples described later. The measurement is performed before addition of other components other than the phenylene ether resin and components used in production of the phenylene ether resin.

The phenylene ether resin composition of the present invention is preferable to have a smaller value of the dissipation factor (Df) at 10 GHz when it is cured. The dissipation factor (Df) of the present phenylene ether resin composition is preferably 0.0005 or more lower than the values of comparative subjects such as the value of the prior art, in a state in which other components other than the phenylene ether resin and components used in production of the phenylene ether resin are not added. It is to be noted that the method described in the Examples described later can be adopted as a method of measuring the dissipation factor.

< Production Method >

The phenylene ether resin composition of the present invention is preferably produced by the following method.

The resin composition of the present invention comprises, as a main resin, a bifunctional phenylene ether resin α, and further comprises a bifunctional phenylene ether resin β and preferably a bifunctional phenylene ether resin γ. Such a bifunctional phenylene ether resin can be obtained by copolymerization reaction of two types of monomer, namely, a monovalent phenol and a divalent phenol. As such a copolymerization reaction, an oxidative polymerization reaction, in which polymerization is carried out by blowing oxygen into the reaction system, is general.

In an oxidative polymerization reaction, polymerization by-products may be generated. One of the factors that greatly affect formation of polymerization by-products is the polymerization time. If the polymerization time is too short, the reaction is terminated while the polymerization is in progress, resulting in a large amount of monomers remaining in the system and the obtaining of phenylene ether resin that has not been elongated to a desired molecular weight. On the other hand, if the polymerization time is long, the blowing of the oxygen into the system is continued, even though the monomers in the system have already been consumed, resulting in an increase in the molecular weight. As a result of our studies, it has been further found that when the polymerization time is long, a part of the molecular structure of the polymerized phenylene ether resin is replaced with a specific structure, and the resin β and the resin γ are generated, in addition to the resin α, which is the main resin. Hereinafter, the substituted phenylene ether resins β and γ, which are substituted with specific structures, are also referred to as "excessive oxidants."

We have also examined polymerization conditions other than the polymerization time as factors, which affect generation of excessive oxidants as by-products. As a result, it became clear that the percentage of excessive oxidants such as the resin b and the resin g changes depending on the metal catalyst equivalent to monomers, the ratio between a metal catalyst and an amine catalyst, the ratio of the two types of monomers, etc. According to the present inventors' studies, it became clear that a phenylene ether resin composition comprising specific amounts of excessive oxidants such as the resin β and the resin γ, as well as the resin α as a main resin, can be obtained by adjusting polymerization conditions and then adjusting the polymerization time.

The specific structure of the excessive oxidant may be the structure of the above general formula (3) or (5). A more specific example of the structure may be a structure, in which when the side chain of the phenylene ether resin is a methyl phenylene group, the methyl group in the methyl phenylene group is substituted with a methoxy group-containing group, an aldehyde group, etc. Although the detailed reaction mechanism for formation of excessive oxidants is unknown, it is assumed that the excessive oxidants are gradually generated as by-products, in relation to the polymerization time, the amount of oxygen blown into the system and the type of a reaction solvent (alcohols such as methanol).

The resins β and γ, which are excessive oxidants, have a structure in which a part of the resin α (main resin) is substituted. In other words, the resins β and γ have a very similar structure to that of the resin α. Accordingly, these resins are not easily removed by a post-treatment or a water-washing step after the polymerization reaction.

In addition, the phenylene ether resin is usually used for various applications after curing. Specifically, after the polymerization step, a polymerizable double bonding group (a styryl group, a methacryl group, etc.) is introduced into the molecular end by performing a reaction of introducing a curing group (a styrylation or methacrylation reaction, etc.), so that the phenylene ether resin is cured. It is still difficult to remove excessive oxidants even in the reaction step of introducing the curing group and in the water-washing step after the reaction. This is because the excessive oxidants still have a very similar structure to that of the resin α, which is the main resin. Therefore, it is likely that excessive oxidants may remain in the resin composition (product) after curing.

The present inventors have thermally cured a phenylene ether resin composition containing excessive oxidants and have then measured the dielectric properties. As a result, the inventors have newly found that there is a correlation between the excessive oxidant content and the high dissipation factor. Thereby, the inventors have found that a resin compositions having a low dissipation factor and excellent dielectric properties can be provided by setting the excessive oxidant content within a specific range.

The oxidative polymerization reaction can be performed by dissolving raw materials such as a monomer, a catalyst and a base in a solvent and then heating and stirring the obtained solution for a certain period of time. The end of

the phenylene ether resin obtained by the oxidative polymerization reaction basically tends to be a hydroxyl group.

The phenylene ether resin $\alpha$ represented by the above general formula (1), which has hydroxyl groups at both ends, can be efficiently produced by subjecting a divalent phenol represented by the following general formula (8) or a monovalent phenol represented by the following general formula (9) alone, or a mixture thereof, to oxidative polymerization in a solvent such as toluene, toluene-alcohol, toluene-ketone, or ketone.

[Formula 18]

the general formula (8)

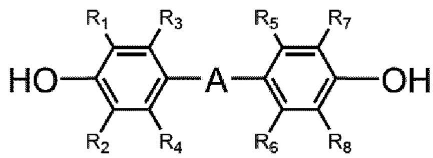

[Formula 19]

the general formula (9)

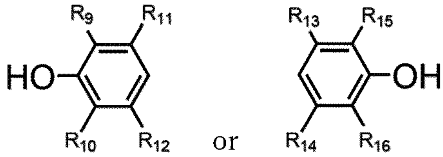

or

Specific examples of the divalent phenol represented by the above general formula (8) may include, but are not limited to, 4,4'-methylenebis(2,6-dimethylphenol), 4,4'-(isopropylidene)bis(2,6-dimethylphenol), 4,4'-methylenebis(2,3,6-trimethylphenol), 4,4'-(isopropylidene)bis(2,3,6-trimethylphenol), 4,4'-cyclohexylidenebis[2,6-dimethylphenol], 4,4'-(phenylmethylene)bis-2,3,6-trimethylphenol, 4,4'-[1,4-phenylenebis(1-methylethylidene)]bis[2,6-dimethylphenol], 4,4'-methylenebis[2,6-bis(1,1-dimethylethyl)phenol], 4,4'-cyclopentylidenebis[2,6-dimethylphenol], 4,4'-[2-furylmethylene]bis(2,6-dimethylphenol), 4,4'-[1,4-phenylenebismethylene]bis[2,6-dimethylphenol], 4,4'-(3,3,5-trimethylcyclohexylidene)bis[2,6-dimethylphenol], 4,4'-[4-(1-methylethyl)cyclohexylidene]bis[2,6-dimethylphenol], 4,4'-(4-methylphenylethylene)bis[2,3,6-trimethylphenol], 4,4'-[1,4-phenylenebismethylene]bis[2,3,6-trimethylphenol], 4-[1-[4-(4-hydroxy-3,5-dimethylphenyl)-4-methylcyclohexyl]-1-methylethyl]-2,6-dimethylphenol, 4,4'-(4-methoxyphenylmethylene)bis[2,3,6-trimethylphenol], 4,4'-[4-(1-methylethyl)phenylmethylene]bis[2,3,6-trimethylphenol], 4,4'-(9H-fluoren-9-ylidene)bis[2,6-dimethylphenol], 4,4'-[1,3-phenylenebis(1-methylethylidene)]bis[2,3,6-trimethylphenol], 4,4'-(1,2-ethanediyl)bis[2,6-di-(1,1-dimethylethyl)phenol], 5,5'-(1-methylethylidene)bis[3-(1,1-dimethylethyl)-1,1-biphenyl-2-ol], 3,3',5,5'-tetramethylbiphenyl-4,4'-diol, and 2,2',3,3',5,5'-hexamethyl-(1,1'-biphenyl)-4,4'-diol.

The divalent phenol represented by the general formula (8) is preferably 4,4'-methylenebis(2,6-dimethylphenol), 4,4'-(isopropylidene)bis(2,6-dimethylphenol), 4,4'-methylenebis(2,3,6-trimethylphenol), 4,4'-(isopropylidene)bis(2,3,6-trimethylphenol), 3,3',5,5'-tetramethylbiphenyl-4,4'-diol, or 2,2',3,3',5,5'-hexamethyl-(1,1'-biphenyl)-4,4'-diol; is more preferably 4,4'-methylenebis(2,6-dimethylphenol), 3,3',5,5'-tetramethylbiphenyl-4,4'-diol, or 2,2',3,3',5,5'-hexamethyl-(1,1'-biphenyl)-4,4'-diol; and is further preferably 2,2',3,3',5,5'-hexamethyl-(1,1'-biphenyl)-4,4'-diol.

The monovalent phenol represented by the general formula (9) is preferably a monovalent phenol alone having substituents at positions 2 and 6; a monovalent phenol alone having substituents at positions 3 and 5; a combined use of a monovalent phenol with substituents at positions 2 and 6 and a monovalent phenol with a substituent(s) at position 3 or at positions 3 and 5. A monovalent phenol alone having substituents at positions 2 and 6 (e.g., 2,6-dimethylphenol) is more preferable.

The substance amount ratio between the monovalent phenol and the divalent phenol to be added as polymerization raw materials (the monomer ratio of the monovalent phenol when the divalent phenol is set to be 1) is not limited, and it may be set within the range in which a bifunctional phenylene ether resin with a number average molecular weight (Mn) of 800 to 3,000 can be obtained. The monomer ratio is preferably 5 to 17.

As an oxidation method, there is a method of directly using oxygen gas or air. There is also an electrode oxidation method. Either method can be applied, and is not particularly limited. Air oxidation is preferable because of its safety and low capital investment.

As catalyst(s) used when oxidative polymerization is carried out using oxygen gas or air, one or two or more types of copper salts, etc., such as CuCl, CuBr, $Cu_2SO_4$, $CuCl_2$, $CuBr_2$, $CuSO_4$, and CuI, are used. In addition to the above-described catalysts, the following amine catalysts may be further used: one or two or more types of amine catalysts, including: monoamine compounds such as mono- and dimethylamine, mono- and diethylamine, mono- and dipropylamine, mono- and di-n-butylamine, mono- and di-sec-dipropylamine, mono- and dibenzylamine, mono- and dicyclohexylamine, mono- and diethanolamine, ethylmethylamine, methylpropylamine, butyldimethylamine, allylethylamine, methylcyclohexylamine, morpholine, methyl-n-butylamine, ethylisopropylamine, benzylmethylamine, octylbenzylamine, octyl-chlorobenzylamine, methyl(phenylethyl)amine, benzylethylamine, N-n-butyldimethylamine, di(chlorophenylethyl) amine, and 1-methylamino-4-pentene; diamine compounds such as N,N'-di-tert-butylethylenediamine; pyridine derivatives such as pyridine, methylpyridine, and 4-dimethylaminopyridine; and piperidine. The catalysts used herein are not particularly limited, as long as they are copper salt and amine catalysts. In particular, a combination of $CuBr_2$, a monoamine compound and a diamine compound is preferable.

From the viewpoint of keeping the excessive oxidant content within the desired range and obtaining a phenylene ether resin having excellent dielectric properties, the substance amount (copper catalyst equivalent) of copper salt used as an oxidative polymerization catalyst is in the range of, preferably 0.2% to 3.0%, particularly preferably 0.5 to 2.0%, and most preferably 0.8% to 2.0%, with respect to the hydroxyl group of the divalent phenol. In addition, the relationship between the substance amounts of copper salt and a diamine compound serving as an amine catalyst "diamine compound/copper salt (catalyst ratio)" is preferably 0.5 to 4.0, and particularly preferably 1.0 to 3.0.

The reaction solvent includes aromatic hydrocarbon solvents such as toluene, benzene and xylene, and halogenated hydrocarbon solvents such as methylene chloride, chloroform and carbon tetrachloride. In addition, these solvents can be used in combination of alcohol solvents or ketone solvents. The alcohol solvent includes methanol, ethanol, butanol, propanol, methyl propylene glycol, diethylene glycol ethyl ether, butyl propylene glycol, and propyl propylene glycol. The ketone solvent includes acetone, methyl ethyl ketone, diethyl ketone, methyl butyl ketone, and methyl isobutyl ketone. Other examples include tetrahydrofuran and dioxane. However, the reaction solvent used herein is not limited to the aforementioned solvents.

The polymerization time is not particularly limited, and it is appropriately determined, so that a phenylene ether resin having a desired number average molecular weight (Mn) and as necessary, a desired weight average molecular weight (Mw), can be obtained. In order to obtain a desired number average molecular weight, etc., the polymerization time needs to be appropriately determined in relation to the catalyst amount, the monomer amount, and the like. On the other hand, as mentioned above, the excessive oxidant is generated as a by-product when the polymerization time is long. Therefore, the polymerization time is preferably determined to be a time in which a desired number average molecular weight, etc. can be obtained, or longer, and a time in which the excessive oxidant is not generated as a by-product to a certain extent, or shorter.

The reaction temperature is not particularly limited, and it is preferably 25°C to 50°C.

The form of polymerization is not particularly limited, and the following two forms are preferable.

The first polymerization form is a method comprising adding all necessary raw materials such as a monomer, a catalyst, a base and a solvent into a polymerization apparatus (reactor), and blowing oxygen into the liquid (bubbling of air) (hereinafter referred to as a "batch method").

The second polymerization form is a method comprising adding a catalyst, a base and a solvent, or a part thereof, into a polymerization apparatus (polymerization tank), then adding the remaining raw materials into the other tank (dropping tank), and then dropping the liquid in the dropping tank into the liquid in the polymerization tank into which air is bubbling (hereinafter referred to as a "dropping method").

The additive amounts of suitable raw materials, the polymerization time, and the like may be determined, depending on the selected polymerization form.

When the resin composition of the present invention is cured, namely, when polymerizable double bond groups are introduced into both ends of the resin $\alpha$ and the resin $\beta$, and preferably, of the resin $\gamma$, then, the obtained bifunctional resin having a phenolic hydroxyl group at the end , and a compound having a polymerizable double bonding group represented by the following general formula (10) or the following general formula (11), are subjected to a dehydrohalogenation reaction under basic conditions in the presence of a phase-transfer catalyst.

[Formula 20]

the general formula (10)

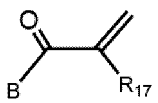

the general formula (11)

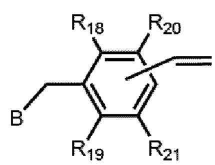

In the general formulae (10) and (11), B represents a halogen (a fluorine atom, a chlorine atom, a bromine atom, or an iodine atom). $R_{17}$ in general formula (10) is the same as that in the above general formula (6), and $R_{18}$ to $R_{21}$ in the

general formula (11) are the same as those in the above general formula (7).

Alternatively, a carboxylic acid anhydride represented by the following general formula (12) may be used, instead of the compound represented by the above general formula (10),

[Formula 21]

the general formula (12)

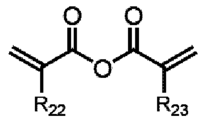

In the general formula (12), $R_{22}$ and $R_{23}$ are the same as $R_{17}$ in the above general formula (6).

Representative examples of the phase transfer catalyst may include, but are not limited to, tertiary amines such as triethylamine and tetramethylethylenediamine, quaternary ammonium salts or quaternary phosphonium salts, such as tetrabutylammonium chloride, tetrabutylammonium bromide, tetrabutylammonium iodide, benzyltri-n-butylammonium chloride, benzyltri-n-butylammonium bromide, and benzyl-n-butylammonium iodide.

Representative examples of the base may include, but are not limited to, sodium hydroxide, potassium hydroxide, sodium methoxide, sodium ethoxide, calcium hydroxide, sodium carbonate, potassium carbonate, and sodium bicarbonate.

The dehydrohalogenation reaction is preferably carried out at a temperature between -10°C and 80°C.

< Other Components >

The phenylene ether resin composition of the present invention may comprise other components other than the bifunctional phenylene ether resin. Hereafter, specific examples of such other components will be described.

(Thermosetting catalyst)

Into the phenylene ether resin composition of the present invention, a thermosetting catalyst can be added for the purpose of accelerate the curing speed to improve workability, economic efficiency, etc. As such a thermosetting catalyst, a thermosetting catalyst, which generates cationic or radical active species capable of initiating polymerization of vinyl group by heat or light, can be used. Examples of the cationic polymerization initiator may include diallyliodonium salts, triallylsulfonium salts, and aliphatic sulfonium salts, which have $BF_4$, $PF_6$, $AsF_6$, and $SbF_6$ as counter anions. As such cationic polymerization initiators, commercially available products, such as SP70, SP172 and CP66 manufactured by ADEKA CORPORATION, CI2855 and CI2823 manufactured by Nippon Soda Co., Ltd., and SI100L and SI150L manufactured by SANSHIN CHEMICAL INDUSTRY CO., LTD., can be used. Examples of the radical polymerization initiator may include benzoin compounds such as benzoin and benzoinmethyl, acetophenone compounds such as acetophenone and 2,2-dimethoxy-2-phenylacetophenone, thioxanthone compounds such as thioxanthone and 2,4-diethylthioxanthone, bisazide compounds such as 4,4'-diazide chalcone, 2,6-bis(4'-azidobenzal)cyclohexanone and 4,4'-diazidobenzophenone, azo compounds such as azobisisobutyronitrile, 2,2-azobispropane and hydrazone, and organic peroxides such as 2,5-dimethyl-2,5-di(t-butylperoxy)hexane, 2,5-dimethyl-2,5-di(t-butylperoxy)hexin-3 and dicumylperoxide. Moreover, $\alpha,\alpha'$-di(t-butylperoxy)diisopropylbenzene ("PERBUTYL P" manufactured by NOF CORPORATION) can also be preferably used. These thermosetting catalysts can be used alone or in a mixture of two or more types.

(Polymerization inhibitor)

Into the phenylene ether resin composition of the present invention, a polymerization inhibitor can also be added to increase storage stability. Known polymerization inhibitors can be used, and examples of the polymerization inhibitor that can be used herein may include quinones such as hydroquinone, methylhydroquinone, p-benzoquinone, chloranil and trimethylquinone, and aromatic diols. In addition, dibutyl hydroxytoluene (BHT), 4-tert-butyl catechol (TBC), 2-nitrophenol, and the like can also be used preferably as polymerization inhibitors. These can be used alone or in a mixture of two or more types.

(Flame retardant, filler, and coupling agent)

Into the phenylene ether resin composition of the present invention, one or more additives selected from a flame retardants a filler made of an inorganic or organic material, and a coupling agent, can also be added as necessary. In

addition, general additive components for resin compositions, which are used in production of electronic devices such as printed wiring boards, may also be added.

Flame retardant

A brominated organic compound, for example, an aromatic bromine compound, can be used as a flame retardant. Specifically, decabromodiphenyl ethane, 4,4-dibromobiphenyl, ethylene bistetrabromophthalimide, etc. can be used. Preferably, a brominated organic compound may be comprised in the resin composition in an amount that the bromine content becomes 8% by mass or more and 20% by mass or less with respect to the total amount of the resin composition.

From the viewpoint of environmental issues, a phosphorus compound may also be used as a flame retardant. Among phosphorus compounds generally used as flame retardants, the phosphorus compound used herein is not particularly limited, as long as it contains a phosphorus atom. Either an inorganic phosphorus compound or an organic phosphorus compound may be used.

Examples of the inorganic phosphorus compound may include red phosphorus, ammonium phosphate, amide phosphate, phosphoric acid, and phosphine oxide.

Examples of the organic phosphorus compound may include an aromatic phosphoric acid ester, a substituted phosphinic acid ester, a nitrogen-containing phosphorus compound, and a cyclic organic phosphorus compound.

Flame retardants may be used alone or in combination with two or more types.

Filler

Examples of the filler may include: fibrous fillers such as glass fiber, carbon fiber, aramid fiber, silicon carbide fiber, alumina fiber, and boron fiber; inorganic whiskers such as silicon carbide, silicon nitride, magnesium oxide, potassium titanate, and aluminoborate; inorganic needle fillers such as wollastonite, zonolite, phosphate fiber, and sepiolite; spherical inorganic fillers such as milled silica, fused silica, talc, alumina, barium titanate, mica, and glass beads; organic fillers such as fine particle polymers obtained by cross-linking (meth)acrylic acid ester, styrene, etc. These can be used alone or in a These can be used alone or in a mixture of two or more types.

As inorganic fillers, metal oxides, nitrides, silicides and borides, such as silica, boron nitride, wollastonite, talc, kaolin, clay, mica, alumina, zirconia, and titania can be used. In particular, by addition of a low dielectric constant filler such as silica or boron nitride, the resin composition is allowed to have a low dielectric constant.

By adding an organic filler to the phenylene ether resin composition of the present invention, the dielectric constant of a prepreg, in which the phenylene ether resin composition of the present invention is used, can be reduced. Examples of the organic filler may include fluorine-based, polystyrene-based, divinylbenzene-based and polyimide-based organic fillers. Examples of the fluorine-based filler (fluorine-containing compound filler) may include polytetrafluoroethylene (PTFE), a polyperfluoroalkoxy resin, a polyfluorinated ethylene propylene resin, a polytetrafluoroethylene-polyethylene copolymer, polyvinylidene fluoride, and polychlorotrifluoroethylene resin. These can be used alone or in combination of multiple fillers.

In addition, as such organic fillers, hollow polymer fine particles can be used. In particular, by using a hollow body whose shell material is a low dielectric constant material such as divinylbenzene or divinylbiphenyl, it is possible to realize a prepreg having a low dielectric constant.

As such inorganic or organic fillers, fine particles having an average particle diameter of 10 $\mu$m or less can be used. The average particle diameter used herein may be the value described in a document such as a catalog of the fillers to be added, or it may also be the average or median value of several fillers randomly selected. By setting the average particle diameter of the filler to be the above-described conditions, a prepreg with high smoothness and reliability can be obtained.

Coupling agent

Examples of the coupling agent may include: silane coupling agents such as vinyltrichlorosilane, vinyltriethoxysilane, vinyltrimethoxysilane, $\gamma$-methacryloxypropyltrimethoxysilane, $\beta$(3, 4-epoxycyclohexyl)ethyltrimethoxysilane, $\gamma$-glycidoxypropylmethyldiethoxysilane, N-$\beta$(aminoethyl) $\gamma$-aminopropylmethylmethoxysilane, $\gamma$-aminopropyltriethoxysilane, N-phenyl-$\gamma$-aminopropyltrimethoxysilane, $\gamma$-mercaptopropyltrimethoxysilane, and $\gamma$-chloropropyl trimethoxy silane; titanate coupling agents; aluminum coupling agents; zirco-aluminate coupling agents; silicone coupling agents; and fluorine coupling agents. These can be used alone or in a mixture of two or more types.

(Crosslinking agent)

From the viewpoint of crosslinking reaction, a crosslinking agent preferably has an average of two or more carbon-carbon unsaturated double bonds or isocyanate groups in a molecule. The crosslinking agent may be composed of one type of compound or two or more types of compounds. The term "carbon-carbon unsaturated double bond" is used in the present description to mean a double bond located at the end branched from the main chain, when the crosslinking agent is a polymer or oligomer.

Examples of the crosslinking agent may include an alkenyl isocyanurate compound, an alkenyl cyanurate compound, a multifunctional methacrylate compound having two or more methacryl groups in the molecule thereof, a multifunctional acrylate compound having two or more acryl groups in the molecule thereof, a multifunctional vinyl compound having two or more vinyl groups in the molecule thereof, a multifunctional vinylphenyl group compound having two or more vinylphenyl groups in the molecule thereof, a styrene derivative, a multifunctional maleimide compound having two or more maleimide groups in the molecule thereof, and multifunctional isocyanate compound having isocyanate groups in the molecule thereof.

The aforementioned alkenyl isocyanurate compound may be a compound having an isocyanurate structure and an alkenyl group in the molecule thereof, and examples of the alkenyl isocyanurate compound may include trialkenyl isocyanurate compounds such as triallyl isocyanurate (e.g., TAIC manufactured by Evonik Industries AG).

The aforementioned alkenyl cyanurate compound may be a compound having a cyanurate structure and an alkenyl group in the molecule, thereof and examples of the alkenyl cyanurate compound may include trialkenyl cyanurate compounds such as triallyl cyanurate (e.g. TAC manufactured by Evonik Industries AG).

The aforementioned multifunctional methacrylate compound may be, for example, tricyclodecanedimethanol dimethacrylate (e.g., DCP manufactured by SHIN-NAKAMURA CHEMICAL Co., Ltd.).

The aforementioned multifunctional vinyl compound may be, for example, a polybutadiene resin. The polybutadiene resin is a polymer synthesized from butadiene monomers such as a butadiene homopolymer or a copolymer of butadiene with another monomer. For example, Ricon100, Ricon184, Ricon267, etc., manufactured by Cray Valley, are preferable.

Examples of the aforementioned multifunctional vinylphenyl compound may include divinylbenzene, ethynylbenzene, and ODV-XET manufactured by NIPPON STEEL Chemical & Material Co., Ltd.

Examples of the aforementioned styrene derivative may include bromostyrene and dibromostyrene.

The aforementioned maleimide compound may include a compound having two or more maleimide groups in the molecule thereof, a compound having one maleimide group in the molecule thereof, and a modified maleimide compound. Among these, a compound having two or more maleimide groups in the molecule thereof is preferably used. Examples of the aforementioned modified maleimide compound may include a modified maleimide compound in which a part of the molecule is amine-modified, and a modified maleimide compound in which a part of the molecule is amine-modified and silicone-modified.

Specific examples of the modified maleimide compound may include (4,4'-methylenediphenyl)bismaleimide (e.g., BMI-70 manufactured by K.I Chemical Industry Co., Ltd., and BMI-1000, BMI-1000H, BMI-1000S, BMI-1100 or BMI-1100H manufactured by Daiwa Fine Chemicals Co., Ltd., Japan), a phenylmaleimide oligomer (e.g., BMI-80 manufactured by K.I Chemical Industry Co., Ltd., and BMI-4000 manufactured by Daiwa Fine Chemicals Co., Ltd., Japan), 3,3'-dimethyl-5,5'-diethyl-4,4'-diphenylethane bismaleimide (e.g., BMI-5100 manufactured by Daiwa Fine Chemicals Co., Ltd., Japan), (4-methyl-1,3'-phenylene)bismaleimide (e.g., BMI-7000H manufactured by Daiwa Fine Chemicals Co., Ltd., Japan), and 1,6-bismaleimide (2,2,4-trimethyl)hexane (e.g., BMI-TMH manufactured by Daiwa Fine Chemicals Co., Ltd., Japan).

Regarding the above-described crosslinking agents, the exemplified crosslinking agents may be used alone or may also be used in combination of two or more types. In addition, regarding the above-described crosslinking agents, not only the aforementioned crosslinking agents such as the compound having two or more unsaturated double bonds in the molecule thereof may be used, but a compound having one unsaturated double bond in the molecule thereof may also be used in combination. The compound having one unsaturated double bond in the molecule thereof may be, for example, a monovinyl compound having one vinyl group in the molecule thereof.

The above-described crosslinking agent preferably has a number average molecular weight of 4,000 or less. When the number average molecular weight of the crosslinking agent is less than 600, the average value of carbon-carbon unsaturated double bonds or isocyanate groups per molecule of the crosslinking agent is preferably 2 to 4. When the number average molecular weight of the crosslinking agent is 600 to 1,500, the average value of carbon-carbon unsaturated double bonds or isocyanate groups per molecule of the crosslinking agent is preferably 4 to 26. When the number average molecular weight of the crosslinking agent is 1,500 to 4,000, the average value of carbon-carbon unsaturated double bonds or isocyanate groups per molecule of the crosslinking agent is preferably 26 to 40.

(Thermoplastic elastomer)

As a thermoplastic elastomer, a commercially available product can be used, as appropriate. Examples of such a thermoplastic elastomer may include: butadiene-based thermoplastic elastomers such as a styrene butadiene copolymer (SBR) and an acrylonitrile butadiene copolymer; styrene-based thermoplastic elastomers such as a styrene butadiene styrene copolymer (SBS), a hydrogenated styrene butadiene styrene copolymer, a styrene isoprene styrene copolymer (SIS), a hydrogenated styrene isoprene styrene copolymer, and a hydrogenated styrene (butadiene/isoprene) styrene copolymer; and thermoplastic resins such as polystyrene, polyester, and polycarbonate. Specific examples may include TR2003 manufactured by JSR Corporation, SEPTON1020, SEPTON4033, SEPTON2104, SEPTON8007L, HYBRAR5127 and HYBRAR7311F manufactured by KURARAY CO., LTD., OP501, HA105, HA125, NB125 and PR803 manufactured by ENEOS Corporation, and Quintone 1340 and Quintone 2940 manufactured by Zeon Corporation.

Among these thermoplastic elastomers, styrene-based thermoplastic elastomers such as a styrene butadiene styrene copolymer, a hydrogenated styrene butadiene styrene copolymer, a styrene isoprene styrene copolymer, a hydrogenated styrene isoprene styrene copolymer, and a hydrogenated styrene (butadiene/isoprene) styrene copolymer are preferable. In particular, a styrene isoprene styrene copolymer, a hydrogenated styrene butadiene styrene copolymer, a hydrogenated styrene isoprene styrene copolymer, a hydrogenated styrene (butadiene/isoprene) styrene copolymer are more preferable because higher heat resistance can be obtained from these styrene-based thermoplastic elastomers.

These thermoplastic elastomers may be used alone or may also be used in combination of two or more types.

(Petroleum resin)

The petroleum resin used in the present invention is a resin obtained by collecting necessary fractions after the pyrolysis of the petroleum naphtha, and then polymerizing the remaining components of the petroleum naphtha without catalysts or in the presence of a catalyst without isolating unsaturated hydrocarbons. The remaining fractions are mainly fractions containing C5 fractions (isoprene, piperylene, cyclopentadiene, pentenes, pentanes, etc.) or C9 fractions (vinyl toluene, indene, dicyclopentadiene, etc.).

In the present invention, from the viewpoint of decreasing the melt viscosity in combination with the phenylene ether resin, a petroleum resin made from a C9 fraction monomer or a dicyclopentadiene monomer as a raw material is preferable.

An acid catalyst is preferable as a catalyst used in production of the petroleum resin. Specific examples of the catalyst that can be used herein may include: Lewis acids such as a boron trifluoride phenol complex, a boron trifluoride ether complex, aluminum chloride, aluminum bromide, iron(III) chloride, and iron(III) bromide; solid acids such as zeolite, silica, montmorillonite, and alumina; ion exchange resins such as a sulfonic acid group-containing fluorine resin and a sulfonic acid group-containing polystyrene resin; and protic acids such as sulfuric acid, hydrochloric acid, acetic acid, phosphoric acid, oxalic acid, nitric acid, p-toluenesulfonic acid, and trifluoroacetic acid. Among these, Lewis acids and solid acids are preferably used because they are less prone to side reactions and provide a high reaction speed. In terms of availability and high reactivity, various complexes of boron trifluoride, and aluminum chloride, are most preferable.

The weight average molecular weight of the petroleum resin is not particularly limited, and it is preferably 500 to 10000, and more preferably 500 to 5000. If the weight average molecular weight is higher than this range, the viscosity is high, and the petroleum resin is hardly miscible with the phenylene ether resin, and also, the solubility in a solvent may below. If the weight average molecular weight is lower than this range, the heat resistance and mechanical strength of the resin may decrease.

The softening point of the petroleum resin is not particularly limited, and it is preferably high, namely, it is preferably 80°C or higher, and more preferably 100°C or higher. If the softening point is lower than this range, the heat resistance of the resin may decrease.

Examples of the dicyclopentadiene-based petroleum resin may include: resins obtained by polymerizing dicyclopentadiene-based fractions, such as dicyclopentadiene, isopropenylnorbornene, dimethyldicyclopentadiene, and tricyclopentadiene; and resins obtained by polymerizing dicyclopentadiene-based fractions and other monomers having unsaturated bonds, preferably, unsaturated cyclic olefins.

Examples of the unsaturated cyclic olefins may include: cyclopentadiene; norbornene-based monomers such as 2-norbornene, 5-methyl-2-norbornene, 5-ethylidene-2-norbornene, 5-phenylnorbornene, and 5-propenyl-2-norbornene,5-ethylidene-2-norbornene; and further, norbornene-based monomers of tricycles or more, which are tricycles other than dicyclopentadiene-based fractions, such as diethyldicyclopentadiene and dihydrodicyclopentadiene, tetracyclics such as tetracyclododecene, pentacyclics such as tricyclopentadiene, heptacyclics such as tetracyclopentadiene, and alkyl-, alkylidene- and aryl-substituted forms of these polycycles. Examples of the alkyl-substituted forms of the above-described polycycles may include methyl-, ethyl-, propyl-, and butyl-substituted forms. An example of the alkylidene-substituted forms of the above-described polycycles may be an ethylidene-substituted form. Further, examples of the aryl-substituted forms may include phenyl-, tolyl-, and naphthyl-substituted forms.

Furthermore, as other monomers having an unsaturated bond, olefins containing 3 to 12 carbon atoms may be copolymerized. Examples of such olefins may include: α-olefins such as propylene, butene-1, pentene-1, 1,3-pentadiene, hexene-1, heptene-1, octene-1, diisobutylene, nonene-1, decene-1, 4-phenylbutene-1, 6-phenylhexene-1, 3-methylbutene-1, 4-methylpentene-1, 3-methylpentene-1, 3-methylhexene-1, 4-methylhexene-1, 5-methylhexene-1, 3,3-dimethylpentene-1, 3,4-dimethylpentene-1, 4,4-dimethylpentene-1, vinylcyclohexane, and vinylcyclohexene; and halogen-substituted α-olefins such as hexafluoropropene, 2-fluoropropene, 3-fluoropropene, and 3,4-dichlorobutene-1.

Examples of other monomers having an unsaturated bond, other than the above-described monomers, may include: ethylene, tetrafluoroethylene, fluoroethylene, 1,1-difluoroethylene, and trifluoroethylene; alkylstyrenes such as styrene, p-methylstyrene, o-methylstyrene, m-methylstyrene, 2,4-dimethylstyrene, 2,5-dimethylstyrene, 3,4-dimethylstyrene, 3,5-dimethylstyrene, and p-t-butylstyrene; halogenated styrenes such as p-chlorostyrene, m-chlorostyrene, o-chlorostyrene, p-bromostyrene, m-bromostyrene, o-bromostyrene, p-fluorostyrene, m-fluorostyrene, o-fluorostyrene, and o-methyl-p-fluorostyrene; and maleic anhydride, maleic acid, fumaric acid, allyl alcohol, 3-buten-2-ol, methylbuten-1-ol, vinyl acetate, and vinyl chloride.

The above-described other monomers having an unsaturated bond may be used alone or may also be used in combination of two or more types.

As such a petroleum resin, a commercially available product can be used as appropriate. Examples of the aliphatic petroleum resin may include: Quintone A100, Quintone B170, Quintone K100, Quintone M100, Quintone R100, and Quintone C200S manufactured by Zeon Corporation; and Marukalets T-100AS, Marukalets R-100AS manufactured by Maruzen Petrochemical CO., LTD. Examples of the aromatic petroleum resin may include: Neopolymer L-90, Neopolymer 120, Neopolymer 130, Neopolymer 140, Neopolymer 150, Neopolymer 170S, Neopolymer 160, Neopolymer E-100, Neopolymer E-130, Neopolymer 130S, and Neopolymer S manufactured by JXTG Nippon Oil & Energy Corporation; and Petokol LX, Petokol LX-HS, Petokol 100T, Petokol 120, Petokol 120HS, Petokol 130, Petokol 140, Petokol 140HM, Petokol 140HM5, Petokol 150, and Petokol 150AS manufactured by TOSOH CORPORATION. Examples of the copolymeric petroleum resin may include: Quintone D100, Quintone N180, Quintone P195N, Quintone S100, Quintone S195, Quintone U185, Quintone G100B, Quintone G115, Quintone D200, Quintone E200SN, and Quintone N295 manufactured by Zeon Corporation; and Petrotack 60, Petrotack 70, Petrotack 90, Petrotack 90V, Petrotack 100, Petrotack 100V, Petrotack 90HM manufactured by TOSOH CORPORATION. Examples of the DCPD (dicyclopentadiene)-based petroleum resin may include: Marukalets M-890A and Marukalets M-845A manufactured by Maruzen Petrochemical CO., LTD.; Quintone 1325, Quintone 1345, Quintone 1500, Quintone 1525L, and Quintone 1700 manufactured by Zeon Corporation; and HA085, HA103, HA105, HA125, HB103, and HB 125 manufactured by ENEOS Corporation.

< Curable film >

Next, the curable film of the present invention will be described. The curable film of the present invention is produced using the phenylene ether resin composition of the present invention, and preferably, the curable film of the present invention is obtained by processing the present phenylene ether resin composition that is in a cured state into a film. The method of processing the present phenylene ether resin composition into a film may be, for example, a method comprising dissolving the resin composition in a solvent, applying the obtained solution onto a release film or a conductor foil such as a copper foil, and drying it.

Examples of the solvent used may include, but are not limited to, acetone, methyl ethyl ketone, ethylene glycol monomethyl ether acetate, propylene glycol dimethyl ether, toluene, xylene, tetrahydrofuran, and N,N-dimethylformamide. These solvents can be used alone or in a mixture of two or more types.

Drying conditions upon the drying of the solvent are not particularly limited. The solvent is preferably dried at a temperature of 80°C to 200°C for 1 to 90 minutes because the solvent easily remains in the curable film at a low temperature and the curing of the phenylene ether resin progresses at a high temperature. The thickness of the curable film can be adjusted based on the concentration of the resin composition solution and the thickness of the coating. If the thickness of the curable film increases, the solvent easily remains upon drying. Thus, the thickness of the curable film is preferably 0.1 to 500 μm.

< Prepreg >

The phenylene ether resin composition of the present invention can be used in production of a prepreg.

First, the phenylene ether resin composition of the present invention, a petroleum resin, and as necessary, other additives are mixed with an organic solvent to form a varnish. The organic solvent is not particularly limited, as long as it dissolves the resin components and does not adversely affect the reaction. For example, the following suitable organic solvents may be used alone or in a mixture of two or more types: aromatic hydrocarbons such as toluene, ketones such as methyl ethyl ketone, ethers such as dibutyl ether, esters such as ethyl acetate, and amides such as dimethyl formamide.

The concentration of the resin solid in the varnish may be adjusted, as appropriate, depending on the operation of impregnating a base material with the varnish, and it can be set to be, for example, 40% by mass or more and 90% by mass or less.

A prepreg can be obtained by impregnating a base material with the varnish, and then heating and drying it to remove the organic solvent and to semi-cure the resin in the base material. A glass cloth can be used as such a base material.

As for the amount of the varnish impregnated into the base material, it is preferably set such that the mass ratio of the resin solid content in the prepreg can be 35% by mass or more. Since the dielectric constant of the base material is larger than that of the resin, in order to reduce the dielectric constant of the printed wiring board obtained using this prepreg, it is good to set the content of the resin solid content in the prepreg to be larger than the above-mentioned mass ratio.

The base material impregnated with the varnish can be heated at a temperature of 80°C or higher and 200°C or lower for 1 minute or more and 10 minutes or less. At this time, it is good to heat the base material so that the minimum melt viscosity of the resin composition in the prepreg becomes 10,000 Pa·s or less. For example, when the base material is heated at a temperature of 150°C, the heating time is desirably 3 minutes or more and less than 10 minutes, and more desirably 5 minutes or more and 9 minutes or less. The heating conditions for the base material impregnated with the varnish are not limited to the above-described conditions, and the conditions are determined so that the minimum melt viscosity of the resin composition in the prepreg becomes 10,000 Pa·s or less. Herein, the minimum melt viscosity of the resin composition in the prepreg is the lowest value of the melt viscosity of the resin composition in the prepreg in the temperature range from room temperature to 200°C.

By low-temperature short-time heating, the melt viscosity decreases due to the remaining solvent, but the dissipation factor of the laminated plate may be deteriorated. On the other hand, by high-temperature, long-time heating, curing progresses and the melt viscosity may become too high. Therefore, from the viewpoint of reduction in the amount of the remaining solvent and suppression of an increase in melt viscosity due to heating, it is desirable that the minimum melt viscosity of the resin composition before heating is low.

In the obtained prepreg, the phenylene ether resin composition of the present invention in a cured state is preferable when the dissipation factor (Df) value at 10 GHz is small. The dissipation factor is preferably 0.0005 or more lower than the comparative subject values of the prior art, etc. in a state where no other components other than the phenylene ether resin and the components used in the production thereof are added.

The base material is not particularly limited, and a known material can be selected and used from various types of printed circuit board materials , as appropriate, depending on the intended use and performance of interest. Specific examples of the fibers that constitute the base material may include, but are not limited to, glass fibers such as E-glass, D-glass, S-glass, Q-glass, NE-glass, NER-glass, L-glass, and T-glass; inorganic fibers other than glass, such as quartz; wholly aromatic polyamides such as poly-para-phenylene terephthalamide (Kevlar®, manufactured by DuPont), copoly-para-phenylene-3,4'-oxy-diphenylene terephthalamide (Technora®, manufactured by TEIJIN TECHNO PRODUCTS LIMITED); polyesters such as 2,6-hydroxy naphthalic acid-para-hydroxy benzoic acid (Vectran®, manufactured by KURARAY CO., LTD.), Zxion®, manufactured by KB SEIREN CO., LTD.); and organic fibers such as poly-p-phenylene benzoxazole (Zylon®, manufactured by Toyobo Co., Ltd.) and polyimide. Among these, from the viewpoint of low thermal expansion coefficient, at least one type selected from the group consisting of E-glass, T-glass, S-glass, Q-glass, and organic fibers is preferable. These base materials may be used alone or in combination with two or more types.

The shape of the base material is not particularly limited, and examples thereof may include a woven fabric, a non-woven fabric, a roving, a chopped strand mat, and a surfacing mat. The method of weaving a woven fabric is not particularly limited, and examples of the known weaving method may include plain weave, basket weave, and twill weave. The weaving method can be selected from these known methods and can be used, as appropriate, depending on the intended use and performance of interest. In addition, the aforementioned fabrics that are subjected to an open fiber treatment, or glass fabrics that have been surface-treated with a silane coupling agent are preferably used. The thickness and mass of the base material are not particularly limited, and in general, those having a thickness of around 0.01 to 0.3 mm are preferably used. In particular, from the viewpoint of strength and water absorbability, a glass fabric having a thickness of 200 μm or less and a mass of 250 g/$m^2$ or less is preferable as a base material, and a glass fabric consisting of the glass fibers of E-glass, S-glass, and T-glass fibers is more preferable.

< Laminated plate >

Using the phenylene ether resin composition of the present invention, a laminated plate can be obtained. For example, using the aforementioned prepreg, a laminated plate can be produced. Hereafter, a method for producing a laminated plate using the prepreg will be described.

First, a single prepreg is placed or multiple prepregs are layered on one another, and then a metal foil such as a copper foil is layered on both sides or one side of the prepreg(s). This laminated plate is subjected to heating pressing molding. As a result of this molding, a laminated plate having a metal foil on both sides or one side (e.g. a copper-clad

laminated plate) can be produced. By patterning and etching the metal foil of this laminated plate to form a circuit, a printed wiring board can be obtained. In addition, multiple prepregs are layered with the metal foil with the circuit formed sandwiched therebetween and are then subjected to heating pressing molding, so that a multilayered printed wiring board can be produced.

The conditions for the heating pressing molding are different depending on the content ratio of the raw materials of the resin composition according to the present invention, and in general, it is preferable to heat and pressurize for an appropriate period of time under conditions of 170°C or higher and 230°C or lower and a pressure of 1.0 MPa or more and 6.0 MPa or less (10 kg/cm$^2$ or more and 60 kg/cm$^2$ or less).

As for the metal foil, there can be used a copper foil with a surface roughness (ten-point average roughness: Rz) of 10 $\mu$m or less, in which the surface on the side where the resin layer is formed by the prepreg (the surface that comes into contact with the prepreg) is treated with zinc or a zinc alloy for rust prevention and for improving adhesion with the resin layer, and the copper foil is further treated with a coupling agent such as a vinyl group-containing silane coupling agent. Such copper foil has good adhesion with the resin layer (insulation layer), and a printed wiring board with excellent high-frequency characteristics can be obtained. When the copper foil is treated with zinc or a zinc alloy, such zinc or a zinc alloy can be formed on the surface of the copper foil by a plating method.

The obtained laminated plate and printed wiring board can realize a low dissipation factor. In addition, a laminated plate and a printed wiring board, which are excellent in terms of heat resistance, flame retardance, toughness, workability, low water absorbability, and glass transition point, can be obtained.

Examples

Hereinafter, the examples of the present invention are described together with comparative example, and the content of the invention is described in detail. However, the present invention is not limited to these examples.

< Measurement of number average molecular weight and weight average molecular weight >

High Performance Liquid Chromatograph HLC-8320GPC, manufactured by Tosoh Techno-System, Inc., was used as a measurement apparatus, and a calibration curve was prepared using standard polystyrene. Utilizing this calibration curve, the number average molecular weight (Mn) and weight average molecular weight (Mw) of the phenylene ether resin were measured. Standard polystyrenes with molecular weights of 706,000, 96,400, 5,970, 474, 370, and 266 were used. Four TSKgel SuperMultipore HZ-N columns manufactured by TOSOH CORPORATION were connected with one another, and were used as a column. As a solvent, tetrahydrofuran was used. The measurement was carried out using a flow rate of the solvent 0.35 mL/min., and a column temperature of 40°C. A sample used for the measurement was prepared by dissolving 0.2 g of a phenylene ether solution in 3 g of a tetrahydrofuran solution. Detection was carried out using a built-in RI detector.

< Analysis of terminal structure by $^1$H-NMR >

A phenylene ether resin composition, into which other components other than a phenylene ether resin and components used in the production of the phenylene ether resin were not added, was concentrated and dried to prepare powders, and the powders were then dissolved in a deuterated chloroform solvent to prepare a solution sample for measurement. The phenylene ether resin was measured using a $^1$H-NMR spectrometer, AVANCEIIIHD500 manufactured by Bruker Corporation, at a measurement temperature of 25°C and with a cumulative number of 64.

< Contents of aldehyde body and methoxy body >

From the measurement results of $^1$H-NMR, the content of an aldehyde body (which has the group shown in the general formula (3), wherein X is a hydrogen atom) and the content of a methoxy body (which has the group shown in the general formula (5), wherein $Y_3$ is a methyl group) were calculated. The integrated intensity of the peak at 1.9 to 2.3 ppm was set to be "1,000". The present peak is attributed to the number of protons of the methyl group substituted on the benzene ring in the resin.

The content of the aldehyde body was calculated according to the following equation:

$$\text{Content [ppm] of aldehyde body} = [\{(I_{9.5\text{-}12.5}/P_a) \times M_a\}/\{(1{,}000/P_p) \times M_p\}] \times 10^6.$$

In the equation,

$I_{9.5\text{-}12.5}$ represents an integrated intensity at 9.5 to 12.5 ppm. This was the measurement value of the number of protons of the aldehyde group in the resin composition.
$P_a$ is the number of protons of the aldehyde group, namely, it is "1,"
$M_a$ is the molecular weight of the aldehyde group, namely, it is 29,
$P_p$ is the number of protons of the methyl group substituted on the benzene ring of the phenylene ether resin $\alpha$, and it was theoretically calculated from the amount of a monomer added.
$M_p$ is the theoretical molecular weight of phenylene ether resin $\alpha$, and it was theoretically calculated from the amount of a monomer added.

In addition, the content of the methoxy body was calculated according to the following equation:

$$\text{Content [ppm] of methoxy body} = [\{(I_{3.2\text{-}3.6}/P_m) \times M_m\}/\{(1,000/P_p) \times M_p\}] \times 10^6.$$

In the equation,

$I_{3.2\text{-}3.6}$ represents an integrated intensity at 3.2 to 3.6 ppm. This was the measurement value of the number of protons of the methoxy group in the resin composition.
$P_m$ is the number of protons of the methoxy group. Since the methoxy group is $-OCH_3$, it is "3,"
$M_m$ is the molecular weight of the methoxy group that is 31,
$P_p$ is the number of protons of the methyl group substituted on the benzene ring of the phenylene ether resin $\alpha$, and it was theoretically calculated from the amount of a monomer added.
$M_p$ is the theoretical molecular weight of phenylene ether resin $\alpha$, and it was theoretically calculated from the amount of a monomer added.

< Comparative Example 1 >

(Synthetic Example 1-1)

A polymerization reaction was carried out according to the following procedures.
Into a vertical reactor equipped with an agitator, a thermometer, an air inlet tube and a baffle plate, the following substances were added, and stirring was carried out at a reaction temperature of 40°C for dissolution:

46.21 g (171 mmol) of 2,2',3,3',5,5'-hexamethyl-(1,1'-biphenyl)-4,4'-diol,
104.4 g (855 mmol) of 2,6-dimethylphenol,
1.37 g (6.1 mmol) of $CuBr_2$,
1.59 g (9.2 mmol) of N,N'-di-t-butylethylenediamine,
9.26 g (92 mmol) of n-butyldimethylamine,
1,000 g of toluene, and
500 g of methanol.

Thereafter, the obtained mixed solution was stirred over 230 minutes, while bubbling a mixed gas obtained by mixing nitrogen and air and by adjusting an oxygen concentration to 8%, into the mixed solution.
Next, 580 of water was added, in which 4.72 g (10 mmol) of tetrasodium ethylenediamine tetraacetate had been dissolved, and the reaction was terminated. An aqueous layer and an organic layer were separated from each other, and the organic layer was then washed with 670 g of pure water. A toluene solution of phenylene ether resin composition was obtained (1,310 g). The number average molecular weight in terms of polystyrene, as calculated by GPC method, was 950, whereas the weight average molecular weight in terms of polystyrene, as calculated by GPC method, was 1,050.

(Synthetic Example 1-2)

A terminal modification reaction was carried out according to the following procedures.
Into a reactor equipped with a stirrer, a thermometer and a reflux tube, the following substances were added, and stirring was carried out at a reaction temperature of 70°C:

1,300 g of a toluene solution of phenylene ether resin composition obtained in Synthesis Example 1-1,
58.0 g (381 mmol) of vinylbenzyl chloride ("CMS-P" manufactured by AGC SEIMI CHEMICAL CO., LTD.),
26 g of tetrabutylammonium bromide (FUJIFILM Wako Pure Chemical Corporation),

6.20 g (0.046 mol) of benzyldimethylamine,
117 g of 48% sodium hydroxide aqueous solution,
180 g of pure water, and
70 g of toluene.

After stirring for 3 hours, an aqueous layer and an organic layer were separated from each other, and the organic layer was washed with 1% sulfuric acid, and then washed with pure water. The obtained solution was concentrated to 65% by mass using an evaporator, so as to obtain 900 g of a phenylene ether resin composition (i) whose terminus was modified to a styryl group. The number average molecular weight in terms of polystyrene, as calculated by GPC method, was 1,220, whereas the weight average molecular weight in terms of polystyrene, as calculated by GPC method, was 1,560.
Various types of values of the phenylene ether resin composition (i) produced in Synthesis Example 1-2 are shown in Table 2. The structure of the main resin (resin $\alpha$) in the phenylene ether resin composition (i) is as follows:

[Formula 22]

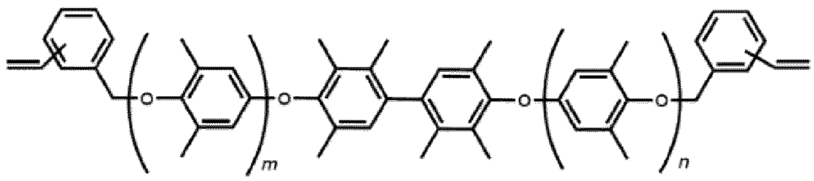

< Example 1 >

(Synthetic Example 2-1)

A polymerization reaction was carried out according to the following procedures.
A toluene solution of phenylene ether resin composition (1,300 g) was obtained in the same manner as that of Synthesis Example 1-1, with the exception that the polymerization time was changed to 210 minutes. The number average molecular weight in terms of polystyrene, as calculated by GPC method, was 930, whereas the weight average molecular weight in terms of polystyrene, as calculated by GPC method, was 1,000.

(Synthetic Example 2-2)

A terminal modification reaction was carried out according to the following procedures.
In the same manner as that of Synthesis Example 1-2, 900 g of a phenylene ether resin composition (ii) whose terminus was modified to a styryl group was obtained. The number average molecular weight in terms of polystyrene, as calculated by GPC method, was 1,220, whereas the weight average molecular weight in terms of polystyrene, as calculated by GPC method, was 1,560.
Various types of values of the phenylene ether resin composition (ii) produced in Synthesis Example 2-2 are shown in Table 2.

< Comparative Example 2 >

(Synthetic Example 3-1)

A polymerization reaction was carried out according to the following procedures.
Into a vertical reactor equipped with an agitator, a thermometer, an air inlet tube and a baffle plate, the following substances were added, and stirring was carried out at a reaction temperature of 40°C for dissolution (preparation of a polymerization tank):

0.685 g (3.1 mmol) of $CuBr_2$,
0.21 g (1.2 mmol) of N,N'-di-t-butylethylenediamine,
4.63 g (46 mmol) of n-butyldimethylamine,
670 g of toluene, and
320 g of methanol.

On the other hand, into another vessel, the following substances had previously been added, and stirring was

carried out at a reaction temperature of 40°C for dissolution (preparation of a dropping tank):

46.21 g (171 mmol) of 2,2',3,3',5,5'-hexamethyl-(1,1'-biphenyl)-4,4'-diol,
104.4 g (855 mmol) of 2,6-dimethylphenol,
0.685 g (3.1 mmol) of $CuBr_2$,
0.21 g (1.2 mmol) of N,N'-di-t-butylethylenediamine,
4.63 g (46 mmol) of n-butyldimethylamine,
440 g of toluene, and
170 g of methanol.

Thereafter, the mixed solution in the dropping tank was added dropwise into the mixed solution in the polymerization tank over 230 minutes, while bubbling a mixed gas of nitrogen and air, which was adjusted to an oxygen concentration of 8%, into the mixed solution in the polymerization tank.

After completion of the dropping, 580 g of water, in which 4.72 g (10 mmol) of tetrasodium ethylenediamine tetraacetate had been dissolved, was added to the reaction mixture, and the reaction was terminated. An aqueous layer and an organic layer were separated from each other, and the organic layer was then washed with 670 g of pure water. A toluene solution of the obtained phenylene ether resin composition was obtained (1,400 g). The number average molecular weight in terms of polystyrene, as calculated by GPC method, was 1,040, whereas the weight average molecular weight in terms of polystyrene, as calculated by GPC method, was 1,120.

(Synthetic Example 3-2)

A terminal modification reaction was carried out according to the following procedures.

In the same manner as that of Synthesis Example 1-2, 950 g of a phenylene ether resin composition (iii) whose terminus was modified to a styryl group was obtained. The number average molecular weight in terms of polystyrene, as calculated by GPC method, was 1,240, whereas the weight average molecular weight in terms of polystyrene, as calculated by GPC method, was 1,670.

Various types of values of the phenylene ether resin composition (iii) produced in Synthesis Example 3-2 are shown in Table 2.

< Example 2 >

(Synthetic Example 4-1)

A polymerization reaction was carried out according to the following procedures.

Into a vertical reactor equipped with an agitator, a thermometer, an air inlet tube and a baffle plate, the following substances were added, and stirring was carried out at a reaction temperature of 40°C for dissolution (preparation of a polymerization tank):

0.31 g (1.4 mmol) of $CuBr_2$,
0.60 g (3.5 mmol) of N,N'-di-t-butylethylenediamine,
4.63 g (46 mmol) of n-butyldimethylamine,
670 g of toluene, and
320 g of methanol.

On the other hand, into another vessel, the following substances had previously been added, and stirring was carried out at a reaction temperature of 40°C for dissolution (preparation of a dropping tank):

46.21 g (171 mmol) of 2,2',3,3',5,5'-hexamethyl-(1,1'-biphenyl)-4,4'-diol,
129.5 g (1,060 mmol) of 2,6-dimethylphenol,
0.31 g (1.4 mmol) of $CuBr_2$,
0.60 g (3.5 mmol) of N,N'-di-t-butylethylenediamine,
4.63 g (46 mmol) of n-butyldimethylamine,
440 g of toluene, and
170 g of methanol.

Thereafter, the mixed solution in the dropping tank was added dropwise into the mixed solution in the polymerization tank over 310 minutes, while bubbling a mixed gas of nitrogen and air, which was adjusted to an oxygen

concentration of 8%, into the mixed solution in the polymerization tank.

After completion of the dropping, 580 g of water, in which 4.72 g (10 mmol) of tetrasodium ethylenediamine tetraacetate had been dissolved, was added to the reaction mixture, and the reaction was terminated. An aqueous layer and an organic layer were separated from each other, and the organic layer was then washed with 670 g of pure water. A toluene solution of the obtained phenylene ether resin composition was obtained (1,400 g). The number average molecular weight in terms of polystyrene, as calculated by GPC method, was 1,050, whereas the weight average molecular weight in terms of polystyrene, as calculated by GPC method, was 1,170.

(Synthetic Example 4-2)

A terminal modification reaction was carried out according to the following procedures.

In the same manner as that of Synthesis Example 1-2, 940 g of a phenylene ether resin composition (iv) whose terminus was modified to a styryl group was obtained. The number average molecular weight in terms of polystyrene, as calculated by GPC method, was 1,210, whereas the weight average molecular weight in terms of polystyrene, as calculated by GPC method, was 1,490.

Various types of values of the phenylene ether resin composition (iv) produced in Synthesis Example 4-2 are shown in Table 2.

< Comparative Example 3 >

(Synthetic Example 5-1)

A polymerization reaction was carried out according to the following procedures.

A toluene solution of phenylene ether resin composition (1,490 g) was obtained in the same manner as that of Synthesis Example 4-1, with the exception that the polymerization time was changed to 350 minutes. The number average molecular weight in terms of polystyrene, as calculated by GPC method, was 1,150, whereas the weight average molecular weight in terms of polystyrene, as calculated by GPC method, was 1,280.

(Synthetic Example 5-2)

A terminal modification reaction was carried out according to the following procedures.

In the same manner as that of Synthesis Example 1-2, 930 g of a phenylene ether resin composition (v) whose terminus was modified to a styryl group was obtained. The number average molecular weight in terms of polystyrene, as calculated by GPC method, was 1,240, whereas the weight average molecular weight in terms of polystyrene, as calculated by GPC method, was 1,500.

Various types of values of the phenylene ether resin composition (v) produced in Synthesis Example 5-2 are shown in Table 2.

< Comparative Example 4 >

(Synthetic Example 6-1)

A polymerization reaction was carried out according to the following procedures.

A toluene solution of phenylene ether resin composition (1,370 g) was obtained in the same manner as that of Synthesis Example 4-1, with the exception that methanol was not used. The number average molecular weight in terms of polystyrene, as calculated by GPC method, was 1,070, whereas the weight average molecular weight in terms of polystyrene, as calculated by GPC method, was 1,180.

(Synthetic Example 6-2)

A terminal modification reaction was carried out according to the following procedures.

In the same manner as that of Synthesis Example 1-2, 980 g of a phenylene ether resin composition (vi) whose terminus was modified to a styryl group was obtained. The number average molecular weight in terms of polystyrene, as calculated by GPC method, was 1,260, whereas the weight average molecular weight in terms of polystyrene, as calculated by GPC method, was 1,540.

Various types of values of the phenylene ether resin composition (vi) produced in Synthesis Example 6-2 are shown in Table 2.

< Example 3 >

(Synthetic Example 7-1)

A polymerization reaction was carried out according to the following procedures.

A toluene solution of phenylene ether resin composition (1,090 g) was obtained in the same manner as that of Synthesis Example 4-1, with the exceptions that 2,2',3,3',5,5'-hexamethyl-(1,1'-biphenyl)-4,4'-diol was changed to 34.22 g (171 mmol) of 4,4'-methylenebis(2,6-dimethylphenol), and that the polymerization time was changed to 280 minutes. The number average molecular weight in terms of polystyrene, as calculated by GPC method, was 1,040, whereas the weight average molecular weight in terms of polystyrene, as calculated by GPC method, was 1,130.

(Synthetic Example 7-2)

A terminal modification reaction was carried out according to the following procedures.

A phenylene ether resin composition (vii) (910 g) was obtained in the same manner as that of Synthesis Example 1-2, with the exception that vinylbenzyl chloride was changed to 39.9 g (381 mmol) of Methacryloyl Chloride (manufactured by Tokyo Chemical Industry Co., Ltd.). The number average molecular weight in terms of polystyrene, as calculated by GPC method, was 1,120, whereas the weight average molecular weight in terms of polystyrene, as calculated by GPC method, was 1,430.

Various types of values of the phenylene ether resin composition (vii) produced in Synthesis Example 7-2 are shown in Table 3. The structure of the main resin (resin $\alpha$) in the phenylene ether resin composition (vii) is as follows.

[Formula 23]

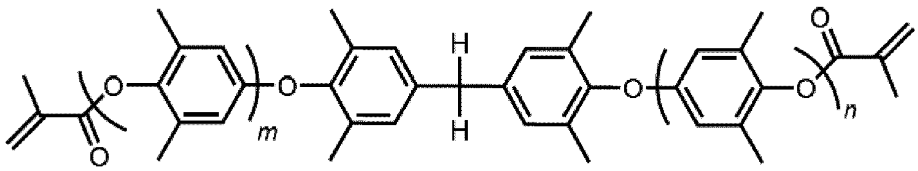

< Comparative Example 5 >

(Synthetic Example 8-1)

A polymerization reaction was carried out according to the following procedures.

A toluene solution of phenylene ether resin composition (1,090 g) was obtained in the same manner as that of Synthesis Example 7-1, with the exceptions that the polymerization time was changed to 320 minutes. The number average molecular weight in terms of polystyrene, as calculated by GPC method, was 1,050, whereas the weight average molecular weight in terms of polystyrene, as calculated by GPC method, was 1,150.

(Synthetic Example 8-2)

A terminal modification reaction was carried out according to the following procedures.

In the same manner as that of Synthesis Example 7-2, 910 g of a phenylene ether resin composition (viii) whose terminus was modified to a methacryl group was obtained. The number average molecular weight in terms of polystyrene, as calculated by GPC method, was 1,130, whereas the weight average molecular weight in terms of polystyrene, as calculated by GPC method, was 1,460.

Various types of values of the phenylene ether resin composition (viii) produced in Synthesis Example 8-2 are shown in Table 3.

< Example 4 >

(Synthetic Example 9-1)

A polymerization reaction was carried out according to the following procedures.

A toluene solution of phenylene ether resin composition (1,350 g) was obtained in the same manner as that of Synthesis Example 4-1. The number average molecular weight in terms of polystyrene, as calculated by GPC method, was 1,060, whereas the weight average molecular weight in terms of polystyrene, as calculated by GPC method, was 1,160.

(Synthetic Example 9-2)

A terminal modification reaction was carried out according to the following procedures.

In the same manner as that of Synthesis Example 8-2, 960 g of a phenylene ether resin composition (ix) whose terminus was modified to a methacryl group was obtained. The number average molecular weight in terms of polystyrene, as calculated by GPC method, was 1,120, whereas the weight average molecular weight in terms of polystyrene, as calculated by GPC method, was 1,470.

Various types of values of the phenylene ether resin composition (ix) produced in Synthesis Example 9-2 are shown in Table 3. The structure of the main resin (resin α) in the phenylene ether resin composition (ix) is as follows.

[Formula 24]

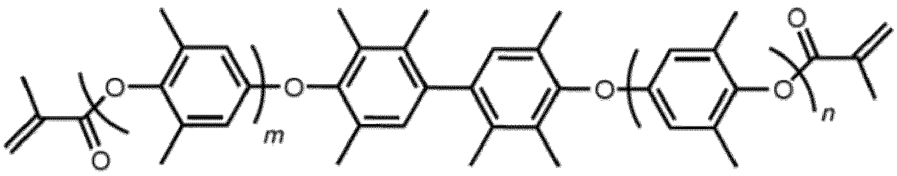

< Comparative Example 6 >

(Synthetic Example 10-1)

A polymerization reaction was carried out according to the following procedures.

A toluene solution of phenylene ether resin composition (1,340 g) was obtained in the same manner as that of Synthesis Example 9-1, with the exceptions that the polymerization time was changed to 350 minutes. The number average molecular weight in terms of polystyrene, as calculated by GPC method, was 1,060, whereas the weight average molecular weight in terms of polystyrene, as calculated by GPC method, was 1,160.

(Synthetic Example 10-2)

A terminal modification reaction was carried out according to the following procedures.

In the same manner as that of Synthesis Example 9-2, 980 g of a phenylene ether resin composition (x) whose terminus was modified to a methacryl group was obtained. The number average molecular weight in terms of polystyrene, as calculated by GPC method, was 1,130, whereas the weight average molecular weight in terms of polystyrene, as calculated by GPC method, was 1,490.

Various types of values of the phenylene ether resin composition (x) produced in Synthesis Example 10-2 are shown in Table 3.

< Preparation of resin cured products >

Cured products were prepared using the powders of the phenylene ether resin compositions (i) to (vi) obtained in Comparative Examples 1 to 4 and Examples 1 and 2.

The powders (4.5 g) of the resin composition were spread over a 100 mm x 30 mm stainless steel mold. The mold was placed in a vacuum pressing machine (manufactured by Oji Machine Co., Ltd.) and was then retained at 200°C for 1.5 hours. Pressing was carried out at a surface pressure of 1.9 MPa.

In addition, the powders of the phenylene ether resin compositions (vii) to (x) obtained in Examples 3 and 4 and Comparison Examples 5 and 6 were pressed in the same manner as that described above, with the exception that α,α'-di(t-butylperoxy)diisopropylbenzene ("PERBUTYL P" manufactured by NOF CORPORATION) was added in an amount of 0.1 wt % and was mixed well with the powders to prepare each phenylene ether resin composition.

< Measurement of dissipation factor >

Using a perturbation-method cavity resonator (Agilent 8722ES, manufactured by Agilent Technologies Japan, Ltd.), the dissipation factors (Df) of the obtained resin cured products at 10 GHz were measured. The measurement temperature was set at 23°C. The measurement results are shown in the following Tables 2 and 3.

Besides, since the value of the dissipation factor varies depending on the molecular structure of the resin and the type and amount of a thermosetting catalyst (polymerization initiator) used to prepare a cured product, upon evaluation of

the high or low dissipation factor, it may be adequate to compare resins that have the same molecular structure or the same type and amount of thermosetting catalyst (polymerization initiator). In the present Examples, for example, it would not make much sense to compare, for example, the resins in Table 2 with the resins in Table 3.

[Table 2]

**Table 2**

| | Comp.Ex. 1 | Ex. 1 | Comp.Ex. 2 | Ex. 2 | Comp.Ex. 3 | Comp. Ex. 4 |
|---|---|---|---|---|---|---|
| Phenylene ether resin | (i) | (ii) | (iii) | (iv) | (v) | (vi) |
| Divalent phenol | HMBP | HMBP | HMBP | HMBP | HMBP | HMBP |
| Polymerizable double bonding group | Styryl group Formula (7) | Styryl group Formula (7) | Styryl group Formula (7) | Styryl group Formula (7) | Styryl group Formula (7) | Styryl group Formula (7) |
| Polymerization form | Batch method | Batch method | Dropping method | Dropping method | Dropping method | Dropping method |
| Solvent for polymerization reaction | Toluene Methanol | Toluene Methanol | Toluene Methanol | Toluene Methanol | Toluene Methanol | Toluene |
| Catalyst ratio (Secondary amine/copper salt) (unit: mole) | 1.5 | 1.5 | 0.4 | 2.5 | 2.5 | 2.5 |
| Copper catalyst equivalent (relative to the number of hy-droxyl groups in divalent phe-nol) | 1.8% | 1.8% | 1.8% | 0.8% | 0.8% | 0.8% |
| Monomer ratio (Monovalent phenol/divalent phenol) | 5 | 5 | 5 | 6.2 | 6.2 | 6.2 |
| Polymerization time [min] (polymerization time in which desired molecular weight is obtained) | 230 | 210 | 230 | 310 | 350 | 310 |
| Content of aldehyde body [ppm] | 210 | 26 | 7,200 | 180 | 220 | 1,100 |
| Content of methoxy body [ppm] | 2,000 | 150 | 1,800 | 240 | 450 | 0 |
| Dissipation factor at 10 GHz | 0.0030 | 0.0023 | 0.0036 | 0.0025 | 0.0030 | 0.0032 |

[Table 3]

**Table 3**

| | Ex. 3 | Comp.Ex. 5 | Ex. 4 | Comp.Ex. 6 |
|---|---|---|---|---|
| Phenylene ether resin | (vii) | (viii) | (ix) | (x) |
| Divalent phenol | TMBPF | TMBPF | HMBP | HMBP |
| Polymerizable double bonding group | Methacryl group Formula (6) | Methacryl group Formula (6) | Methacryl group Formula (6) | Methacryl group Formula (6) |

(continued)

| | Ex. 3 | Comp.Ex. 5 | Ex. 4 | Comp.Ex. 6 |
|---|---|---|---|---|
| Polymerization form | Dropping method | Dropping method | Dropping method | Dropping method |
| Solvent for polymerization reaction | Toluene Methanol | Toluene Methanol | Toluene Methanol | Toluene Methanol |
| Catalyst ratio (Secondary amine/-copper salt) (unit: mole) | 2.5 | 2.5 | 2.5 | 2.5 |
| Copper catalyst equivalent (relative to the number of hydroxyl groups in divalent phenol) | 0.8% | 0.8% | 0.8% | 0.8% |
| Monomer ratio (Monovalent phenol/divalent phenol) | 6.2 | 6.2 | 6.2 | 6.2 |
| Polymerization time [min] (Polymerization time in which desired molecular weight is obtained) | 280 | 320 | 310 | 350 |
| Content of aldehyde body [ppm] | 200 | 270 | 180 | 220 |
| Content of methoxy body [ppm] | 330 | 550 | 240 | 450 |
| Dissipation factor at 10 GHz | 0.0045 | 0.0050 | 0.0046 | 0.0051 |

Abbreviations used in the above Table 2 and Table 3:

HMBP: 2,2',3,3',5,5'-hexamethyl-(1,1'-biphenyl)-4,4'-diol
TMBPF: 4,4'-methylenebis(2,6-dimethylphenol)

## Claims

**1.** A phenylene ether resin composition having a number average molecular weight (Mn) of 800 to 3,000,

the phenylene ether resin composition comprising a resin α represented by the following general formula (1) and a resin β represented by the following general formula (2), wherein
the phenylene ether resin composition is **characterized in that** the content of the resin β to the resin α (the content of the resin β/the content of the resin α) is 20 to 200 ppm:

[Formula 1]
the general formula (1)

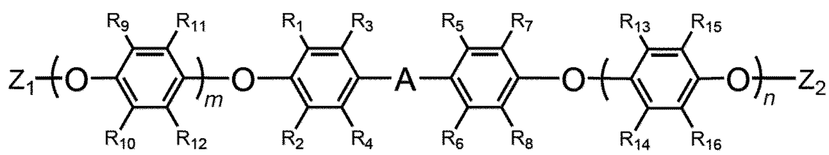

wherein A represents a single bond or a linear, branched or cyclic hydrocarbon containing 10 or less carbon atoms; $Z_1$ and $Z_2$, which may be the same or different, each represent a hydrogen atom or a unit containing a polymerizable double bonding group; $R_1$ to $R_{16}$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group or a substituted aryl group; m and n each represent an integer of 0 to 20, and at least one is an integer of 1 to 20; and at least one of $R_1$ to $R_{16}$ represents a methyl group, and

[Formula 2]

the general formula (2)

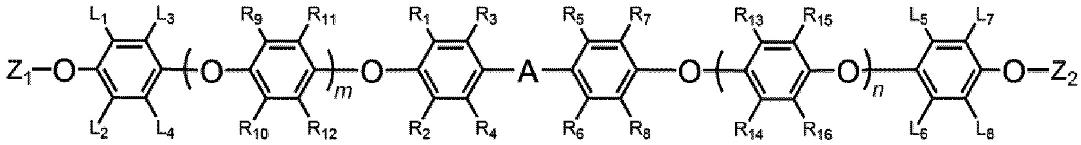

wherein A, $Z_1$, $Z_2$, $R_1$ to $R_{16}$, m and n are the same as those in the general formula (1); and $L_1$ to $L_8$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group, a substituted aryl group or the following general formula (3), wherein at least one of $L_1$ to $L_8$ is represented by the following general formula (3):

[Formula 3]

the general formula (3)

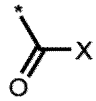

wherein X is selected from the group consisting of a hydrogen atom, a hydroxyl group, a linear or branched alkyl group containing 6 or less carbon atoms, a substituted alkyl group, an alkenyl group, a substituted alkenyl group, an aryl group and a substituted aryl group; and * represents a bonding hand.

**2.** The phenylene ether resin composition according to claim 1, further comprising a resin $\gamma$ represented by the following general formula (4), wherein

the content of the resin $\gamma$ to the resin $\alpha$ (the content of the resin $\gamma$/the content of the resin $\alpha$) is 150 to 400 ppm:

[Formula 4]

the general formula (4)

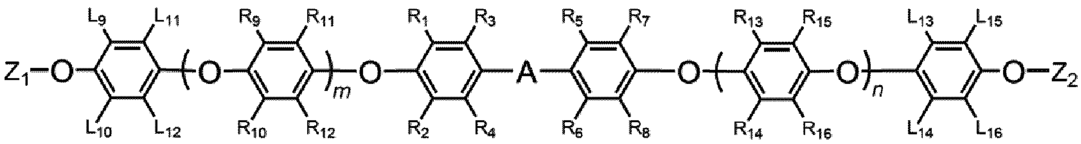

wherein A, $Z_1$, $Z_2$, $R_1$ to $R_{16}$, m and n are the same as those in the general formula (1); $L_9$ to $L_{16}$, which may be the same or different, each represent a hydrogen atom, a halogen atom, a linear, branched or cyclic alkyl group containing 6 or less carbon atoms, a substituted alkyl group, an alkenyl group, a substituted alkenyl group, an aryl group, a substituted aryl group or the following general formula (5), wherein at least one of $L_9$ to $L_{16}$ is represented by the following general formula (5):

[Formula 5]

the general formula (5)

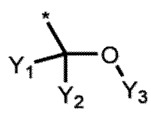

wherein $Y_1$ and $Y_2$ are selected from the group consisting of a hydrogen atom, a linear or branched alkyl group containing 6 or less carbon atoms, a substituted alkyl group, an alkenyl group, a substituted alkenyl group, an aryl group and a substituted aryl group; $Y_3$ is selected from the group consisting of a hydrogen atom, a linear or branched alkyl group containing 6 or less carbon atoms, a substituted alkyl group, an alkenyl group and a

substituted alkenyl group; and * represents a bonding hand.

3. The phenylene ether resin composition according to claim 1, wherein, in the general formulae (1) and (2), A is a single bond.

4. The phenylene ether resin composition according to claim 1, wherein, in the general formulae (1) and (2), $R_1$, $R_2$, $R_3$, $R_6$, $R_7$ and $R_8$ each represent a methyl group, and $R_4$ and $R_5$ each represent a hydrogen atom.

5. The phenylene ether resin composition according to claim 1, wherein

in the general formulae (1) and (2), $R_9$, $R_{10}$, $R_{15}$ and $R_{16}$ each represent a methyl group, and $R_{11}$, $R_{12}$, $R_{13}$ and $R_{14}$ each represent a hydrogen atom, and
in the general formula (2), $L_1$, $L_2$, $L_7$ and $L_8$ each represent a methyl group or the general formula (3), and $L_3$, $L_4$, $L_5$ and $L_6$ each represent a hydrogen atom, wherein at least one of $L_1$, $L_2$, $L_7$ and $L_8$ represents the general formula (3).

6. The phenylene ether resin composition according to claim 1, wherein

in the general formulae (1) and (2), $Z_1$ and $Z_2$ are represented by either the following general formula (6) or (7):

[Formula 6]

the general formula (6)

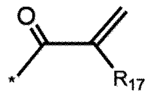

wherein $R_{17}$ represents a hydrogen atom or a methyl group; and * represents a bonding hand, or

[Formula 7]

the general formula (7)

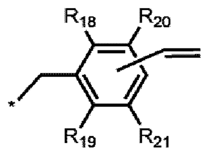

wherein $R_{18}$ to $R_{21}$, which may be the same or different, each represent a hydrogen atom, a halogen atom, a linear or branched alkyl group containing 6 or less carbon atoms or a phenyl group; and * represents a bonding hand.

7. The phenylene ether resin composition according to claim 6, wherein, in the general formulae (1) and (2), $Z_1$ and $Z_2$ are represented by the general formula (7).

8. The phenylene ether resin composition according to claim 1, wherein, in the general formula (3), X represents a hydrogen atom.

9. The phenylene ether resin composition according to claim 2, wherein, in the general formula (5), $Y_3$ represents a methyl group.

10. A curable film obtained using the phenylene ether resin composition according to any one of claims 1 to 9.

11. A laminated plate obtained using the phenylene ether resin composition according to any one of claims 1 to 9.

## INTERNATIONAL SEARCH REPORT

International application No. **PCT/JP2023/027019**

**A. CLASSIFICATION OF SUBJECT MATTER**

***C08F 299/00***(2006.01)i
FI: C08F299/00

According to International Patent Classification (IPC) or to both national classification and IPC

**B. FIELDS SEARCHED**

Minimum documentation searched (classification system followed by classification symbols)

C08F299/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY(STN)

**C. DOCUMENTS CONSIDERED TO BE RELEVANT**

| Category* | Citation of document, with indication, where appropriate, of the relevant passages | Relevant to claim No. |
|---|---|---|
| X | JP 2009-24167 A (MITSUBISHI GAS CHEM. CO., INC.) 05 February 2009 (2009-02-05) claims, paragraph [0007], examples | 1-11 |
| A | JP 2004-59644 A (MITSUBISHI GAS CHEM. CO., INC.) 26 February 2004 (2004-02-26) entire text | 1-11 |
| A | JP 2014-162850 A (ASAHI KASEI E-MATERIALS CORP.) 08 September 2014 (2014-09-08) entire text | 1-11 |
| A | US 2017/0088669 A1 (ELITE MATERIAL CO., LTD.) 30 March 2017 (2017-03-30) entire text | 1-11 |

☐ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 September 2023** | **03 October 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/027019**

| Patent document cited in search report | Publication date (day/month/year) | Patent family member(s) | Publication date (day/month/year) |
|---|---|---|---|
| JP 2009-24167 A | 05 February 2009 | US 2009/0012331 A1<br>claims, paragraph [0019], examples<br>EP 2006318 A1<br>CN 101328265 A<br>KR 10-2008-0111405 A<br>TW 200909476 A<br>HK 1125958 A | |
| JP 2004-59644 A | 26 February 2004 | US 2004/0198863 A1<br>entire text<br>EP 1384733 A1<br>TW 200408650 A<br>KR 10-2004-0010389 A<br>CN 1480439 A | |
| JP 2014-162850 A | 08 September 2014 | (Family: none) | |
| US 2017/0088669 A1 | 30 March 2017 | TW 201712052 A<br>CN 106554498 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003012796 A
- JP 2004059644 A